# EUROPÄISCHE PATENTSCHRIFT

(11) **EP 3 715 503 B1**
(45) Veröffentlichungstag und Bekanntmachung des Hinweises auf die Patenterteilung: **19.03.2025**
(21) Anmeldenummer: 20154576.1
(22) Anmeldetag: 30.01.2020
(51) Int. Cl.: C23C 16/54, C23C 16/458, C23C 16/46, C23C 14/50, C23C 14/56, C23C 14/54, B65H 20/12

(54) **TEMPERIERROLLE, TRANSPORTANORDNUNG UND VAKUUMANORDNUNG**
TEMPERING ROLLER, A TRANSPORT ARRANGEMENT AND A VACUUM ARRANGEMENT
ROULEAU DE MISE EN TEMPÉRATURE, AGENCEMENT DE TRANSPORT ET AGENCEMENT SOUS VIDE

(30) Priorität: 26.03.2019 DE 102019107719
(43) Veröffentlichungstag der Anmeldung: 30.09.2020
(73) Patentinhaber: VON ARDENNE Asset GmbH & Co. KG, 01328 Dresden (DE)
(72) Erfinder: WEHNER, Uwe, 01796 Pirna (DE); PÜNSCH, Thomas, 01259 Dresden (DE); ZAHN, Richard, 01900 Großröhrsdorf (DE); NIEDERHAUSEN, Thomas, 01279 Dresden (DE)

(56) Entgegenhaltungen:
- EP-A1- 0 311 302
- EP-B1- 0 311 302
- WO-A1-2017/207053
- GB-A- 2 326 647
- JP-A- 2016 088 663
- US-A1- 2010 291 308
- US-A1- 2012 006 520
- US-A1- 2014 057 448

## Beschreibung

Die Erfindung betrifft eine Temperierrolle, eine Transportanordnung und eine Vakuumanordnung.

Im Allgemeinen kann ein Substrat derart behandelt (prozessiert), z.B. beschichtet werden, dass die chemischen und/oder physikalischen Eigenschaften des Substrats verändert werden können. Zum Beschichten eines Substrats können verschiedene Beschichtungsverfahren durchgeführt werden, wie beispielsweise eine Gasphasenabscheidung, z.B. eine chemische Gasphasenabscheidung (CVD) oder eine physikalische Gasphasenabscheidung (PVD).

Im Allgemeinen können flexible Substrate in Form eines Bands (z.B. Metallband, Folienband oder Glasband) in einer Durchlaufanlage prozessiert, z.B. in einer Folienbeschichtungsanlage beschichtet (und/oder anderweitig behandelt), werden. Dabei kann beispielsweise ein Bandsubstrat mittels einer Transportanordnung durch einen Prozessierbereich hindurch transportiert werden. Die Transportanordnung kann beispielsweise derart eingerichtet sein, dass das Bandsubstrat von Rolle-zu-Rolle (auch als R2R bezeichnet) prozessiert wird, wobei das Bandsubstrat von einem ersten Substrat-Wickel abgewickelt wird, durch den Beschichtungsbereich hindurch transportiert wird, und nach dem Beschichten auf einen zweiten Substrat-Wickel wieder aufgewickelt wird (auch als Umwickeln bezeichnet). Dabei kann die Beschichtungsanlage eine Vakuumkammer aufweisen, so dass das Bandsubstrat im Vakuum prozessiert werden kann. Der Substrat-Wickel kann beispielsweise in die Vakuumkammer eingeschleust oder aus dieser ausgeschleust werden, so dass die Vakuumkammer zyklisch belüftet werden muss zum Austauschen des Bandsubstrats.

Für einige Transportvorrichtungen kann es erforderlich sein, dass deren Transportrolle einen besonders hohen thermischen Kontakt zu dem Substrat bereitstellt, um dieses zu erwärmen und/oder zu kühlen (allgemeiner auch als temperieren bezeichnet). Der thermische Kontakt kann beispielsweise verbessert werden, indem zwischen das Substrat und die Transportrolle ein Gas eingebracht wird, welches die fehlende Wärmeleitfähigkeit des Vakuums überbrückt. Anschaulich füllt das Gas verbleibende Hohlräume zwischen dem Substrat und der Transportrolle auf und verbessert durch vielfache wechselseitige Berührung der Gasteilchen (z.B. Gasmoleküle) die Wärmeübertragung zwischen diesen.

Die GB 2 326 647 A beschreibt, dass ein Substrat kontaktlos gelagert werden kann, indem ein Gaspolster mittels einer separaten Einspritzdüse zwischen eine Trommel und das Substrat eingeblasen wird. Die US 2014/057448 A1 beschreibt eine Blaswalze, bei der das Gas aus der Blaswalze selbst austritt. Die EP0 311 302A1 beschreibt ebenso eine Einspritzdüse, um Gas zwischen eine Folie und eine Kühltrommel einzubringen. Die JP2016088663A beschreibt eine Trommel mit mehreren außenliegenden porösen Schichten. Die Erfindung wird durch die abgehängten Ansprüche definiert.

Gemäß verschiedenen Ausführungsformen wurde anschaulich erkannt, dass die Wärmeübertragung ein empfindliches Gleichgewicht benötigt. Einerseits sollte das Gas gleichmäßig aus der Transportrolle (z.B. Walzenoberfläche) ausströmen in einer Menge, welche die Hohlräume auch füllt. Andererseits sollte die Menge des Gases so bemessen sein, dass es nicht zum Abheben des Substrates von der Transportrolle (z.B. Walzenoberfläche) kommt.

Gemäß verschiedenen Ausführungsformen werden eine temperierende Transportrolle (auch als Temperierrolle bezeichnet) und eine Vakuumanordnung bereitgestellt, welche es ermöglichen, ein Substrat während des Beschichtungsprozesses effektiv zu temperieren.

Anschaulich weist die Temperierrolle eine Gasverteilungsstruktur auf, welche das Gas effektiver über die Oberfläche der Transportrolle verteilt.

Gemäß verschiedenen Ausführungsformen kann eine Temperierrolle aufweisen: eine zylinderförmige Rollenhülle, welche eine Vielzahl von Gasaustrittsöffnungen aufweist; eine Temperiervorrichtung (z.B. Kühlvorrichtung), welche eingerichtet ist, der zylinderförmigen Rollenhülle thermische Energie zuzuführen und/oder zu entziehen; mehrere entlang der Drehachse erstreckte Gasleitungen; eine Gasverteilungsstruktur, welche die mehreren Gasleitungen und die Vielzahl von Gasaustrittsöffnungen gasleitend miteinander koppelt, wobei die Gasverteilungsstruktur eine kleinere Strukturdichte aufweist als die Vielzahl von Gasaustrittsöffnungen.

Es zeigen
Figuren 1, 2, 3, 10, 11, 12 jeweils eine Transportanordnung gemäß verschiedenen Ausführungsformen in verschiedenen Ansichten;
Figuren 4, 6, 7, 8, 9, 13A, 13B, 13C, 14 und 15 jeweils eine Temperierrolle gemäß verschiedenen Ausführungsformen in verschiedenen Ansichten;
Figuren 16A, 16B, 16C und 17 jeweils eine Temperierrolle gemäß verschiedenen Ausführungsformen in verschiedenen Ansichten;

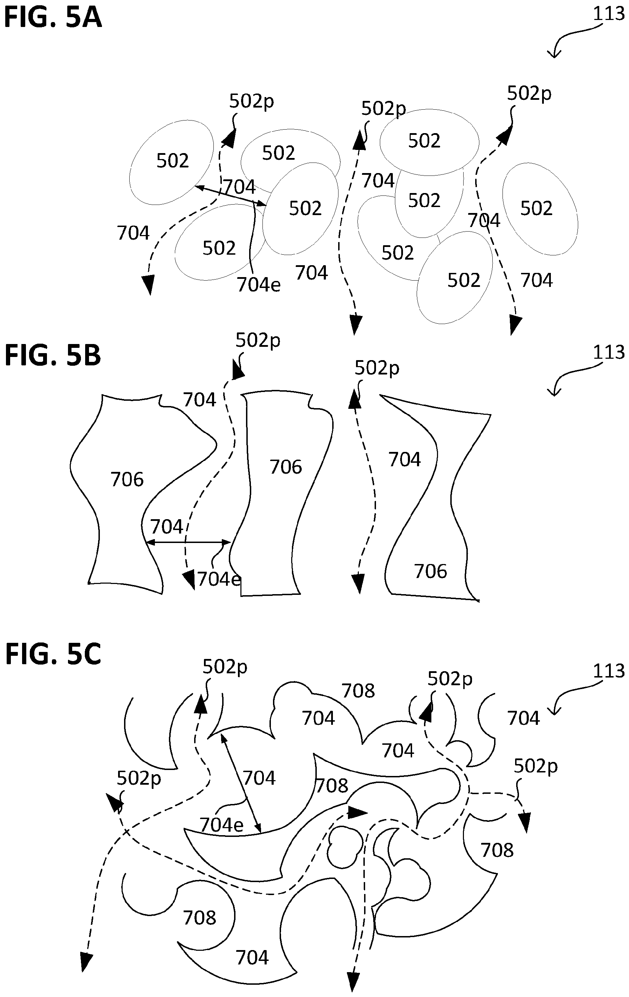

Figur 5A, 5B und 5C jeweils einen porösen Festkörper 113 gemäß verschiedenen Ausführungsformen in einer schematischen Querschnittsansicht; und

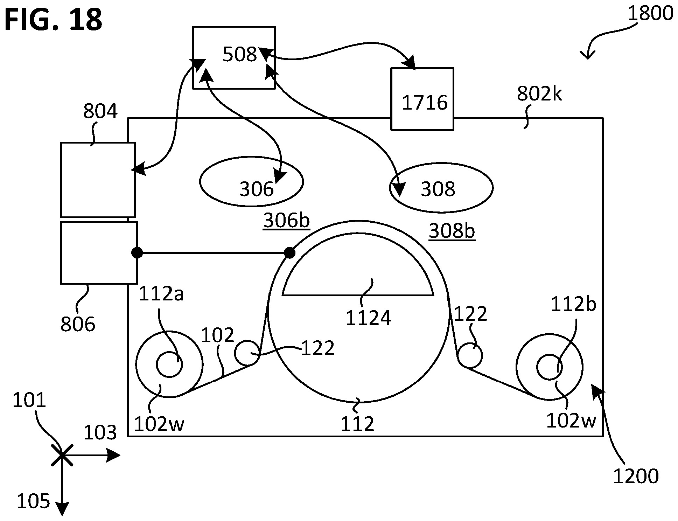

Figur 18 eine Vakuumanordnung gemäß verschiedenen Ausführungsformen in einer schematischen Seitenansicht oder Querschnittsansicht.

In der folgenden ausführlichen Beschreibung wird auf die beigefügten Zeichnungen Bezug genommen, die Teil dieser bilden und in denen zur Veranschaulichung spezifische Ausführungsformen gezeigt sind, in denen die Erfindung ausgeübt werden kann. In dieser Hinsicht wird Richtungsterminologie wie etwa "oben", "unten", "vorne", "hinten", "vorderes", "hinteres", usw. mit Bezug auf die Orientierung der beschriebenen Figur(en) verwendet. Da Komponenten von Ausführungsformen in einer Anzahl verschiedener Orientierungen positioniert werden können, dient die Richtungsterminologie zur Veranschaulichung und ist auf keinerlei Weise einschränkend. Es versteht sich, dass andere Ausführungsformen benutzt und strukturelle oder logische Änderungen vorgenommen werden können, ohne von dem Schutzumfang der vorliegenden Erfindung abzuweichen. Es versteht sich, dass die Merkmale der hierin beschriebenen verschiedenen beispielhaften Ausführungsformen miteinander kombiniert werden können, sofern nicht spezifisch anders angegeben. Die folgende ausführliche Beschreibung ist deshalb nicht in einschränkendem Sinne aufzufassen, und der Schutzumfang der vorliegenden Erfindung wird durch die angefügten Ansprüche definiert.

Im Rahmen dieser Beschreibung werden die Begriffe "verbunden", "angeschlossen" sowie "gekoppelt" verwendet zum Beschreiben sowohl einer direkten als auch einer indirekten Verbindung (z.B. ohmsch und/oder elektrisch leitfähig, z.B. einer elektrisch leitfähigen Verbindung), eines direkten oder indirekten Anschlusses sowie einer direkten oder indirekten Kopplung. In den Figuren werden identische oder ähnliche Elemente mit identischen Bezugszeichen versehen, soweit dies zweckmäßig ist.

Gemäß verschiedenen Ausführungsformen kann der Begriff "gekoppelt" oder "Kopplung" im Sinne einer (z.B. mechanischen, hydrostatischen, thermischen und/oder elektrischen), z.B. direkten oder indirekten, Verbindung und/oder Wechselwirkung verstanden werden. Mehrere Elemente können beispielsweise entlang einer Wechselwirkungskette miteinander gekoppelt sein, entlang welcher die Wechselwirkung (z.B. ein Signal) übertragen werden kann. Beispielsweise können zwei miteinander gekoppelte Elemente eine Wechselwirkung miteinander austauschen, z.B. eine mechanische, hydrostatische, thermische und/oder elektrische Wechselwirkung. Gemäß verschiedenen Ausführungsformen kann "gekuppelt" im Sinne einer mechanischen (z.B. körperlichen bzw. physikalischen) Kopplung verstanden werden, z.B. mittels eines direkten körperlichen Kontakts. Eine Kupplung kann eingerichtet sein, eine mechanische Wechselwirkung (z.B. Kraft, Drehmoment, etc.) zu übertragen.

Das Steuern kann verstanden werden als eine beabsichtigte Beeinflussung eines Systems. Dabei kann der Zustand des Systems gemäß einer Vorgabe verändert werden. Regeln kann als Steuern verstanden werden, wobei zusätzlich einer Zustandsänderung des Systems durch Störungen entgegengewirkt wird. Anschaulich kann eine Steuervorrichtung eine nach vorn gerichtete Steuerstrecke aufweisen und somit anschaulich eine Ablaufsteuerung implementieren, welche eine Eingangsgröße in eine Ausgangsgröße umsetzt. Die Steuerstrecke kann aber auch Teil eines Regelkreises sein, so dass eine Regelung implementiert wird. Die Regelung weist im Gegensatz zu der reinen Vorwärts-Steuerung eine fortlaufende Einflussnahme der Ausgangsgröße auf die Eingangsgröße auf, welche durch den Regelkreis bewirkt wird (Rückführung). Mit anderen Worten kann alternativ oder zusätzlich zu der Steuervorrichtung eine Regelung verwendet werden bzw. alternativ oder zusätzlich zu dem Steuern ein Regeln erfolgen. Bei einer Regelung wird ein Ist-Wert der Regelgröße (z. B. basierend auf einem Messwert ermittelt) mit einem Führungswert (einem Sollwert oder einer Vorgabe oder einem Vorgabewert) verglichen und entsprechend kann die Regelgröße mittels einer Stellgröße (unter Verwendung eines Stellglieds) derart beeinflusst werden, dass sich möglichst eine geringe Abweichung des jeweiligen Ist-Werts der Regelgröße vom Führungswert ergibt.

Ein poröser Körper oder Bereich kann verstanden werden als dass dieser ein heterogenes Gemisch aus einem festem Material und einem fluiden (z.B. gasförmigen und/oder flüssigen) Material aufweist.

Gemäß verschiedenen Ausführungsformen kann der Begriff porös oder Porosität bezogen auf ein Material verstanden werden, als dass das Material eine feste Matrix (d.h. einen Festkörper) bildet, in welchem eine Vielzahl Hohlräume angeordnet ist. Mit anderen Worten kann das Material als der Anteil eines porösen Körpers oder porösen Bereichs verstanden werden, welcher in einem festen Aggregatszustand vorliegt. Gemäß verschiedenen Ausführungsformen kann als Porosität des Körpers oder Bereichs eine dimensionslose Messgröße verstanden werden, welche das Verhältnis von Hohlraumvolumen (Volumen der Hohlräume oder des fluiden Materials darin) zu Gesamtvolumen (Hohlraumvolumen plus das Volumen des festen Materials) bezeichnet, welches die feste Matrix aufspannt.

Gemäß verschiedenen Ausführungsformen kann der Begriff porös oder Porosität bezogen auf einen Bereich oder einen Körper (z.B. die Gasverteilungsstruktur oder die Rollenhülle) verstanden werden, als dass der Bereich oder der Körper die feste Matrix sowie die Hohlräume bzw. das fluide Material darin aufweist. Mit anderen Worten kann als Porosität eine dimensionslose Messgröße verstanden werden, welche das Verhältnis des Volumens an fluidem Material in dem Körper oder Bereich zu dem Gesamtvolumen des Bereichs oder des Körpers bezeichnet. Eine Massendichte des Bereichs oder des Körpers kann mit steigender Porosität abnehmen, anschaulich da die Hohlräume berücksichtigt werden.

Die Porosität kann dann definiert sein als 1 minus dem Quotienten aus Rohdichte (des Körpers) und Reindichte. Die Reindichte gibt die Dichte des festen Materials bzw. der festen Matrix (d.h. exklusive der Hohlräume) an, während die Rohdichte auf das Volumen des Körpers einschließlich der Hohlräume bzw. des fluiden Materials darin bezogen ist.

Die Porendichte gibt das Verhältnis aus Anzahl der Poren zur Fläche (auch als Porenflächendichte bezeichnet) oder aus Anzahl der Poren zur Länge (auch als Porenstreckendichte oder lineare Porendichte bezeichnet) an. Die für Öffnungen (z.B. Kanäle, Durchgangsöffnungen, Poren oder andere Hohlräume) verallgemeinerte physikalische Größe ist die Strukturdichte, z.B. die Strukturflächendichte (structure area density) oder lineare Strukturdichte (structure linear density). Die lineare Strukturdichte kann beispielsweise analog zum Linienschnittverfahren die Anzahl von Grenzen zwischen Hohlräumen entlang eines Schnittes angeben. Die physikalische Größe, welche auf diejenigen Öffnungen bezogen ist, welche den Festkörper (z.B. eine Schicht) auch durchdringen, d.h. welche zur Gasleitfähigkeit (auch als Permeabilität bezeichnet) beitragen, kann als Gasleitungsstrukturdichte bezeichnet sein.

Ist der Festkörper beispielsweise offenporig, kann dessen Porendichte gleich der Gasleitungsstrukturdichte sein. Ist der Festkörper perforiert oder von Gaskanälen durchdrungen, kann die Dichte der Perforierungen bzw. Gaskanäle gleich der Gasleitungsstrukturdichte sein.

Die Öffnungen des Festkörpers können je nach ihrer Größe als Poren, Gaskanäle, Perforierungen oder Gasleitungen bezeichnet sein. Als Perforierung kann eine technisch erzeugte und/oder regelmäßig angeordnete Durchlochung verstanden werden. Die Ausdehnung der oder jeder Perforierung kann (z.B. entlang der Drehachse) größer sein als ungefähr 1 mm, z.B. als ungefähr 2 mm, z.B. als ungefähr 5 mm, z.B. als ungefähr 10 mm.

Die Permeabilität ist anschaulich ein Maß zur Quantifizierung der Durchlässigkeit eines Festkörpers für Fluide (beispielsweise für eine Flüssigkeit oder ein Gas). Die Permeabilität kann beispielsweise gemäß dem Darcyschen Gesetz definiert sein oder werden. Eine physikalische Einheit für die Gasdurchlässigkeit durch einen Festkörper (auch als Permeabilität bezeichnet) ist beispielsweise das Perm (in Quadratmeter). Liegt keine Durchlässigkeit vor, so spricht man von Impermeabilität.

Ein flexibles Substrat kann während eines Beschichtungsprozesses temperiert werden. Dazu kann eine flüssigkeitsgekühlte Walze (auch als Transportrolle bezeichnet) verwendet werden, über die das Substrat geführt wird. Aufgrund des anschaulich schlechten Wärmeübergangs zwischen Substrat und Walzenoberfläche ist die Temperierung allerdings nicht immer ausreichend. Eine Verbesserung des Wärmeübergangs kann durch das Einbringen eines Gases zwischen Substrat und Walzenoberfläche erreicht werden.

Mit anderen Worten kann das Substrat einen Kontakt zur Walzenoberfläche aufweisen. Mikroskopisch gesehen, hat die Rollenhülle (auch als Walzenmantel oder Außenmantel bezeichnet) berührende Substratoberfläche eine gewisse Rauheit, die auf der Rauheit der Walzenoberfläche jeweils entsprechend punktuell aufliegt. Die Zwischenräume zwischen den beiden Oberflächenrauheiten werden mit Gasteilchen ausgefüllt. Diese Gasteilchen übernehmen einen Teil des Wärmetransports zwischen der Walze und dem Substrat. Die Anzahl der Gasteilchen ist über den Gasdruck bestimmt.

Die Walzenoberfläche (auch als Temperierfläche bezeichnet) der Temperierrolle kann aus einem elektrisch nicht leitfähigen Material (z.B. einer Keramik) bestehen. Um den Anpressdruck des Substrates an die Temperierrolle zusätzlich zu dem aus dem Bandzug resultierenden Anpressdruck erhöhen zu können, kann die Temperierrolle mit einer elektrischen Spannung beaufschlagt werden. Durch die elektrisch isolierende Walzenoberfläche kann ein Potentialunterschied zwischen Temperierrolle und Substrat bereitgestellt sein oder werden, welcher aufgrund der dadurch bewirkten elektrostatischen Anziehung eine Erhöhung des Anpressdruckes bereitstellen kann. Der Gasdruck kann entsprechend somit erhöht werden, ohne dass das Substrat abhebt, was den Wärmeübergang verbessert.

Die Temperierrolle kann einen doppelwandigen Temperierwalze-Körper (auch als Rollengehäuse oder vereinfacht als Gehäuse bezeichnet), z.B. einen Kühlwalzenkörper, aufweisen. Über den Außenmantel des entsprechend mechanisch bearbeiteten Gehäuses kann ein zusätzlicher dünner Außenmantel aus mikroperforiertem Blech (z.B. Edelstahlblech) aufgeschrumpft sein oder werden. Auf dem Blech kann ein Schichtsystem aus unterschiedlich porösen Materialien angeordnet sein oder werden. Den freiliegenden Abschluss der Temperierrolle kann eine sehr feinporige elektrisch nicht leitfähige Deckschicht bilden.

Wird ein Gas zwischen das Rollengehäuse und dem perforierten Blech eingelassen, kann sich dieses durch die spezielle mechanische Bearbeitung des Rollengehäuses unterhalb des Bleches verteilen und aus den Perforationsschlitzen (auch als Schlitze bezeichnet) in das poröse Schichtsystem einströmen. Durch das poröse Schichtsystem wird das Gas sehr homogen auf die gesamte Temperierfläche verteilt und strömt schließlich nahezu vollflächig aus der Temperierfläche aus.

Der Außenmantel des (z.B. doppelwandigen) Gehäuses kann mit einer gewindeähnlichen Rillen-Struktur versehen sein, die wiederum durch längs zur Walzenachse verlaufende Nuten unterbrochen wird. Anzahl und Tiefe der Rillen und Nuten kann derart bemessen sein oder werden, dass ein gewisses Gasvolumen aufgenommen werden kann. Die Nuten können durch entsprechende Bohrungen von der Stirnseite des Außenmantels her mit einer Gasversorgung verbunden sein oder werden. Das aufgeschrumpfte Blech (z.B. Edelstahlblech) kann in einem Bereich, aus dem schließlich Gas ausströmen soll, mit Schlitzen (z.B. 0,3 mm breit und 7 mm lang) versehen sein.

Da das Blech die Rillen und Nuten des Gehäuses abdeckt, kann das Gas nur durch die entsprechend überlappenden Schlitze hindurch strömen. Das Blech kann mit dem Schichtsystem aus unterschiedlich porösen Schichten beschichtet sein oder werden. Durch die untere offen-poröse Schicht kann eine gute Querverteilung des Gases innerhalb dieser Schicht erreicht sein oder werden. Die darüber liegende sehr gering-poröse (auch als feinporöse bezeichnet) Schicht aus nichtleitfähigem Material kann einen Druckabfall bereitstellen und/oder weiterhin bereitstellen, dass das Gas in sehr geringer Menge aus den vielen kleinen Poren sehr gleichmäßig und vollflächig aus der Temperierfläche austritt.

Optional kann diese äußerste und freiliegende Schicht (auch als Abschlussschicht bezeichnet) der Temperierrolle aus einem elektrisch nicht leitfähigen Material hergestellt sein oder werden. Durch Anlegen einer elektrischen Spannung an die unter dieser Abschlussschicht liegende elektrisch leitfähige Schicht kann bei Bedarf ein Potentialunterschied zum Substrat bereitgestellt sein oder werden, wodurch eine elektrostatische Anziehung zwischen der Temperierrolle und dem Substrat bewirkt werden kann.

Gemäß verschiedenen Ausführungsformen kann die bereitgestellte Temperierrolle ermöglichen, den Wärmeübergang zwischen der Temperierrolle und dem Substrat zu verbessern. Damit können wesentlich günstigere Prozessbedingungen geschaffen werden.

Gemäß verschiedenen Ausführungsformen kann das Substrat (z.B. das Bandsubstrat) zumindest eines von Folgendem aufweisen oder daraus gebildet sein: eine Keramik, ein Glas, einen Halbleiter (z.B. einen amorphen, polykristallinen oder einkristallinen Halbleiter, z.B. Silizium), ein Metall (z.B. Aluminium, Kupfer, Eisen, Stahl, Platin, Gold, etc.), ein Polymer (z.B. Kunststoff) und/oder eine Mischung verschiedener Materialien, wie z.B. ein Verbundwerkstoff (z.B. Kohlenstofffaserverstärkter-Kohlenstoff, oder Kohlenstofffaser-verstärkter-Kunststoff). Beispielsweise kann das Substrat (z.B. das Bandsubstrat) eine Kunststofffolie, eine Halbleiterfolie, eine Metallfolie und/oder eine Glasfolie aufweisen oder daraus gebildet sein, und optional beschichtet sein oder werden. Alternativ oder zusätzlich kann das Substrat beispielsweise Fasern aufweisen, z.B. Glasfasern, Kohlenstofffasern, Metallfasern und/oder Kunststofffasern, z.B. in Form eines Gewebes, eines Netzes, eines Gewirks, Gestricks oder als Filz bzw. Flies.

Gemäß verschiedenen Ausführungsformen kann ein Substrat als Band (auch als Bandsubstrat bezeichnet) von Rolle-zu-Rolle transportiert werden (d.h. zwischen den Umwickelrollen umgewickelt werden). Das Bandsubstrat kann beispielsweise eine Breite (Ausdehnung quer zur Transportrichtung) in einem Bereich von ungefähr 1 cm (z.B. 30 cm) bis ungefähr 500 cm aufweisen oder eine Breite (auch als Substratbreite bezeichnet) von mehr als ungefähr 500 cm. Ferner kann das Bandsubstrat flexibel sein. Anschaulich kann ein Bandsubstrat ein beliebiges Substrat sein, welches auf eine Rolle aufgewickelt werden kann und/oder beispielsweise von Rolle-zu-Rolle prozessiert werden kann. Das Bandsubstrat kann je nach Elastizität des verwendeten Materials eine Materialstärke (auch als Substratdicke bezeichnet) in einem Bereich von ungefähr einigen Mikrometern (z.B. von ungefähr 1 µm) bis ungefähr einigen Millimetern (z.B. bis ungefähr 10 mm) aufweisen, z.B. in einem Bereich von ungefähr 0,01 mm bis ungefähr 3 mm. Die Transportrollen der Transportanordnung können axial länger sein, als das Bandsubstrat breit ist.

Im Rahmen dieser Beschreibung kann der Begriff "metallisch" verstanden werden als ein Metall aufweisend oder daraus gebildet. Im Rahmen dieser Beschreibung kann ein Metall (auch als metallischer Werkstoff bezeichnet) zumindest ein metallisches Element (d.h. ein oder mehrere metallische Elemente) aufweisen (oder daraus gebildet sein), z.B. zumindest ein Element aus der Folgenden Gruppe von Elementen: Kupfer (Cu), Eisen (Fe), Titan (Ti), Nickel (Ni), Silber (Ag), Chrom (Cr), Platin (Pt), Gold (Au), Magnesium (Mg), Aluminium (Al), Zirkonium (Zr), Tantal (Ta), Molybdän (Mo), Wolfram (W), Vanadium (V), Barium (Ba), Indium (In), Calcium (Ca), Hafnium (Hf), Samarium (Sm), Silber (Ag), und/oder Lithium (Li). Ferner kann ein Metall eine metallische Verbindung (z.B. eine intermetallische Verbindung oder eine Legierung) aufweisen oder daraus gebildet sein, z.B. eine Verbindung aus zumindest zwei metallischen Elementen (z.B. aus der Gruppe von Elementen), wie z.B. Bronze oder Messing, oder z.B. eine Verbindung aus zumindest einem metallischen Element (z.B. aus der Gruppe von Elementen) und mindestens einem nichtmetallischen Element (z.B. Kohlenstoff), wie z.B. Stahl.

Eine Transportrolle kann, je nach Anwendungszweck und Konfiguration, verschieden ausgestaltet sein oder werden. Beispielsweise kann eine Transportrolle als (z.B. aktive oder passive) Führung und/oder Umlenkung des Transportpfads, zum Temperieren (z.B. Kühlen) oder Antreiben des Substrattransports eingerichtet sein. Eine solche Transportrolle zum Temperieren (auch als Temperierrolle bezeichnet), z.B. eine Kühlrolle, kann beispielsweise angetrieben sein und deren Drehung das Antreiben des Substrattransports bewirken. Die Temperierrolle kann beispielsweise eine Keramikoberfläche aufweisen (z.B. eine Stahlwalze), die beispielsweise aufgespritzt sein kann.

Gemäß verschiedenen Ausführungsformen wird eine geregelte Gaszuführung zu einer Temperierrolle (in dem Fall auch als Gastemperierwalze oder Gastemperierrolle bezeichnet), z.B. Kühlwalze (in dem Fall auch als Gaskühlwalze oder Gaskühlrolle bezeichnet), bereitgestellt mittels Gasaustauschöffnungen in der Temperierrolle. Eine solche Temperierrolle kann beispielsweise in einer Vakuumanlage zur Metallbandbeschichtung und/oder Folienbandbeschichtung eingesetzt werden. Mit der (z.B. geregelten) Gaszuführung einer Temperierrolle wird ein Abheben des Substrats von der Temperierrolle verhindert und ausreichend Gas zum Temperieren des Substrats zugeführt.

Gemäß verschiedenen Ausführungsformen wird eine Temperierrolle (z.B. als Prozesswalze für Folienbeschichtungsanlagen) bereitgestellt, mittels welcher ein Gas (z.B. Argon, Stickstoff oder ein anderes Inertgas) zwischen die Temperierfläche (auch als Hüllfläche, Mantelfläche oder Umfangsfläche der Temperierrolle 112 bezeichnet) der Temperierrolle (z.B. Prozesswalze) und das Substrat eingebracht werden kann. Hierzu weist die Temperierfläche der Temperierrolle radiale Gasaustauschöffnungen auf. Die Gasaustauschöffnungen können gemeinsam mittels eines Netzwerks von untereinander verbundenen Poren untereinander verbunden sein und/oder mit Gas versorgt werden, z.B. mittels mehrerer Gasleitungen. An der Stirnseite der Prozesswalze kann optional für jede Gasleitung ein in dem Gehäuse der Temperierwalze verschraubtes Anschlussstück angeordnet sein. Jedes Anschlussstück kann beispielsweise mittels einer Leitungsstruktur verbunden sein.

Als Mantelfläche (auch Hüllfläche) eines Körpers kann die (z.B. umlaufende) Oberfläche, die durch Rotation einer Linie um eine Drehachse herum entsteht, verstanden werden. Die äußerste Mantelfläche der Temperierrolle, die freiliegt und auf der das Substrat anliegen soll, kann auch als Temperierfläche bezeichnet sein. Mittels der Temperierfläche kann dem Substrat thermische Energie zugeführt und/oder entzogen werden.

Im Folgenden wird auf den Prozess des Kühlens Bezug genommen zum einfacheren Verständnis, d.h. auf das Entziehen von thermischer Energie. Das Beschriebene kann analog allerdings auch für den Prozess des Erwärmens gelten, d.h. für das Zuführen von thermischer Energie. Das Kühlen und/oder Erwärmen können allgemeiner auch als Temperieren bezeichnet werden.

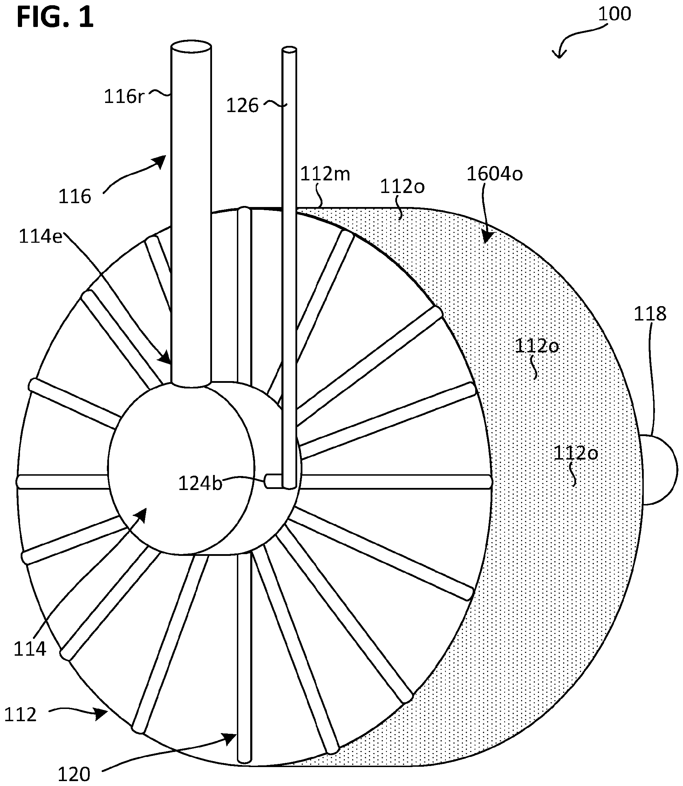

**Fig.1** veranschaulicht eine Transportanordnung 100 gemäß verschiedenen Ausführungsformen in einer schematischen Perspektivansicht.

Die Transportanordnung 100 kann aufweisen: eine Temperierrolle 112 (z.B. eine Gaskühlrolle 112 bzw. Gaskühlwalze), welche eine (z.B. zylindrische) Rollenhülle 112m und eine Versorgungsvorrichtung 114 aufweist. Die Versorgungsvorrichtung 114 und die Temperierrolle 112 können gemeinsam, z.B. aneinander montiert, oder auch einzeln, z.B. separat voneinander, bereitgestellt sein oder werden.

Die Rollenhülle 112m kann die Substrat-Auflagefläche 1604o (auch als Temperierfläche 1604o der Temperierrolle 112 bezeichnet), auf welcher das Substrat aufliegen soll, bereitstellen.

Die Rollenhülle 112m (auch als Rollenmantel oder Außenmantel bezeichnet) kann eine Vielzahl von Gasaustrittsöffnungen 112o (auch als Öffnungen 112o bezeichnet) aufweisen. Die Gasaustrittsöffnungen 112o können beispielsweise statistisch und/oder unregelmäßig auf der äußeren, freiliegenden, Substrat-Auflagefläche 1604o der Rollenhülle 112m angeordnet und/oder räumlich verteilt sein. Die Gasaustrittsöffnungen 112o können in der Substrat-Auflagefläche gebildet sein oder werden und/oder sich in die Rollenhülle 112m hinein erstrecken.

Die Rollenhülle 112m kann beispielsweise ein Dielektrikum (z.B. ein Oxid) aufweisen oder daraus gebildet sein. Alternativ oder zusätzlich kann die Rollenhülle 112m Aluminium und/oder Zirkon (Zr) aufweisen oder daraus gebildet sein, z.B. ein Oxid dessen. Das Oxid der Rollenhülle 112m kann auch ein Oxid eines anderen Metalls sein, z.B. von Chrom (Chromoxid), von Titan (Titanoxid) und/oder von Yttrium (Yttriumoxid) aufweisen oder daraus gebildet sein. Beispielsweise kann die Rollenhülle 112m einen Massenanteil von ungefähr 15% (oder weniger) Zirkonoxid (ZrO₂) aufweisen oder daraus gebildet sein und beispielsweise den Rest Aluminiumoxid (Al₂O₃).

Die Versorgungsvorrichtung 114 kann einen Anschluss 114e (z.B. einen Temperierflüssigkeit-Anschluss, z.B. Kühlflüssigkeit-Anschluss) und einen zweiten Anschluss 124b (z.B. einen Temperiergas-Anschluss, z.B. Kühlgas-Anschluss) aufweisen.

In einem montierten Zustand und/oder im Betrieb kann der erste Anschluss 114e mit einer Kühlflüssigkeit-Versorgung 116 fluidleitend (z.B. flüssigkeitsleitend) verbunden sein. Die Kühlflüssigkeit-Versorgung 116 kann beispielsweise eine Pumpe und/oder einen Wärmetauscher aufweisen. Alternativ oder zusätzlich kann die Kühlflüssigkeit-Versorgung 116 eine Rohrleitung 116r aufweisen, welche beispielsweise die Pumpe mit dem ersten Anschluss 114e fluidleitend verbindet.

In einem montierten Zustand und/oder im Betrieb kann der zweite Anschluss 124b mit einer Kühlgas-Versorgung fluidleitend (z.B. gasleitend) verbunden sein. Die Kühlgas-Versorgung kann beispielsweise eine Gasquelle, wie beispielsweise einen Gastank, eine Gasflasche oder Ähnliches aufweisen. Optional kann die Kühlgas-Versorgung eine Rohrleitung 126 aufweisen, welche die Gasquelle mit dem zweiten Anschluss 124b fluidleitend verbindet und/oder zum Steuern (und/oder Regeln) eines Gasflusses in dieser eingerichtet ist (z.B. mittels eines Ventils), z.B. auf Grundlage eines Gasdrucks in der Vakuumkammer und/oder einer Temperatur des Substrats.

Die Transportanordnung 100 kann ferner eine Welle 118 aufweisen, mittels welcher die Temperierrolle 112 (z.B. drehbar) gelagert ist. Die Welle 118 kann sich in die Versorgungsvorrichtung 114 hinein erstrecken und/oder in dieser drehbar abgestützt sein.

In einem montierten Zustand und/oder im Betrieb kann die Transportanordnung 100 optional einen Antrieb (nicht dargestellt) aufweisen, welcher mit der Welle 118 gekuppelt ist, beispielsweise auf der der Versorgungsvorrichtung 114 gegenüberliegenden Seite der Welle 118.

Die Transportanordnung 100 kann ferner eine Leitungsstruktur 120 aufweisen, welche den ersten Anschluss 114e mit einer Kühlvorrichtung (nicht dargestellt) und/oder den zweiten Anschluss 124b mit den Gasaustrittsöffnungen 112o fluidleitend verbindet.

Optional kann die Temperierfläche der Rollenhülle 112m elektrisch isolierend (z.B. dielektrisch) eingerichtet sein oder zumindest ein elektrisch isolierendes Material (z.B. ein Dielektrikum) aufweist oder daraus gebildet sein. Beispielsweise kann die Rollenhülle 112m eine Keramik aufweisen oder daraus gebildet sein, zum Beispiel eine oxydische Keramik oder eine karbidische Keramik. Damit kann verhindert werden, dass eine an die Gasverteilungsstruktur 402 angelegte elektrische Spannung mit dem Substrat kurzschließt. Beispielsweise kann eine Durchbruchspannung der Rollenhülle 112m mehr als 1000 Volt (V) sein, z.B. mehr als ungefähr 2000 Volt (V), oder mehr als 3000 Volt (V).

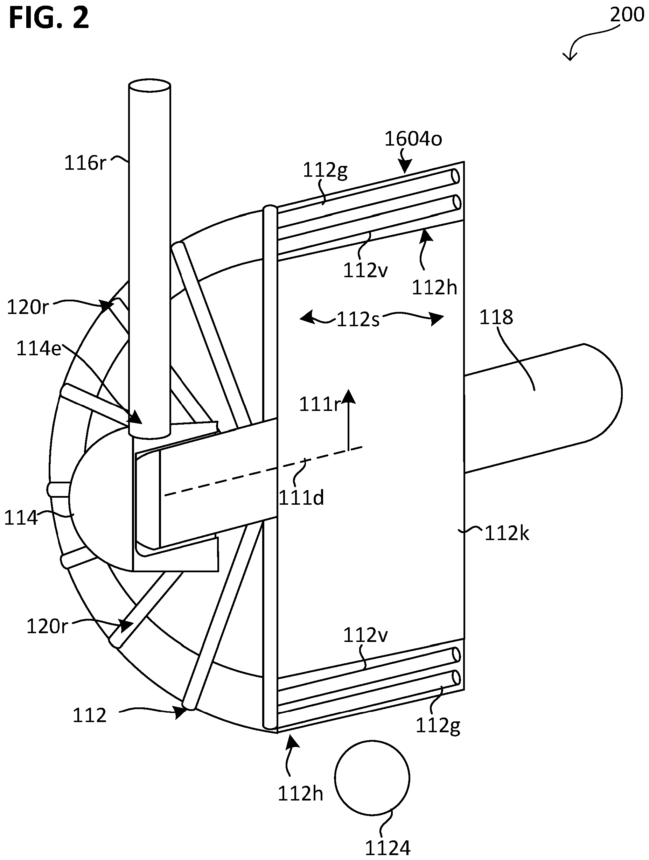

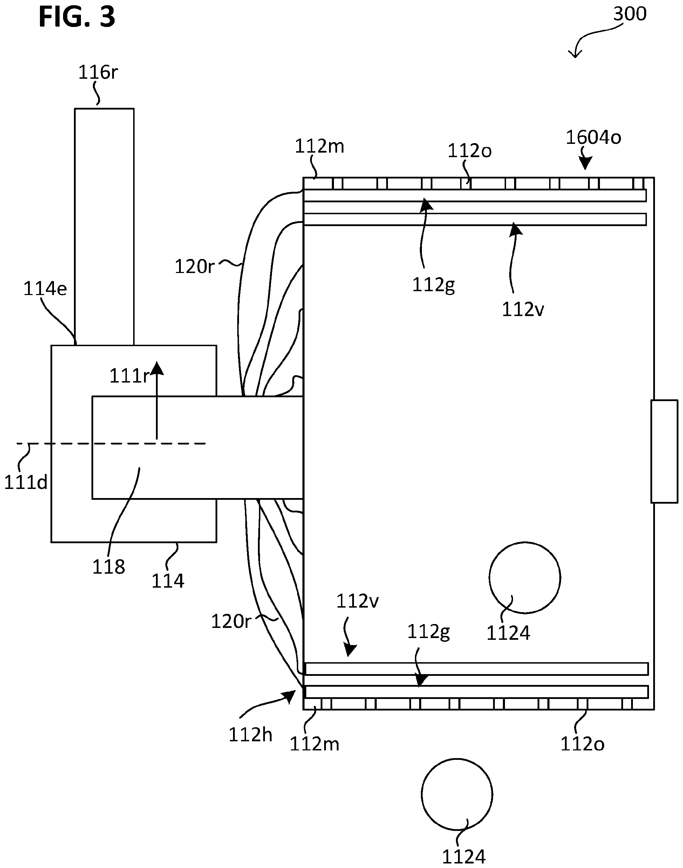

**Fig.2** veranschaulicht eine Transportanordnung 200, z.B. Transportanordnung 100, gemäß verschiedenen Ausführungsformen in einer schematischen perspektivischen Querschnittsansicht und **Fig.3** diese in einer schematischen seitlichen Querschnittsansicht 300 (beide geschnitten entlang der Drehachse 111d der Transportanordnung 200).

Die Transportanordnung 200 kann zumindest eine Kühlvorrichtung 1124 aufweisen, welche beispielsweise eine (z.B. elektrische) Wärmesenke bereitstellen kann, z.B. mittels eines Wärmetauschers. Die Kühlvorrichtung 1124 und/oder zumindest eines ihrer Bestandteile kann beispielsweise innerhalb der Temperierrolle 112 angeordnet sein. Alternativ oder zusätzlich kann die oder eine zusätzliche Kühlvorrichtung 1124 (und/oder ein anderes ihrer Bestandteile) außerhalb der Temperierrolle 112 angeordnet sein.

Die (z.B. rotationssymmetrische) Rollenhülle 112m bzw. deren Temperierfläche 1604o kann anschaulich die äußere, freiliegende Oberfläche der Temperierrolle 112 bereitstellen.

Das Rollengehäuse 112h (z.B. in Form eines Hohlzylinders bereitgestellt) kann eine (z.B. zylindermantelförmige) Kammer aufweisen, z.B. einen Doppel-Hohlzylinder, welche mittels Stirnwänden 112s (stirnseitig und/oder vakuumdicht) abge- und/oder verschlossen ist.

Die Kühlvorrichtung 1124 kann einen oder mehrere Hohlräume 112v (auch als Kühlleitungen 112v bezeichnet) in dem Rollengehäuse 112h (auch als Walzengrundkörper 112h oder Walzenaußenrohr 112h bezeichnet) aufweisen.

Die Temperierrolle 112 kann einen oder mehr als einen zusätzlichen axial erstreckten Hohlraum 112g (auch als Gasleitung 112g bezeichnet) aufweisen, von denen jede Gasleitung 112g mit der Vielzahl von Gasaustrittsöffnungen 112o fluidleitend (gasleitend) verbunden ist, z.B. mittels der Gasverteilungsstruktur wie später noch genauer beschrieben wird. Die mehreren Gasleitungen 112g können beispielsweise parallel zueinander erstreckt und/oder nebeneinander angeordnet sein, z.B. die Drehachse 111d umgebend.

Die Leitungsstruktur 120 kann mit der einen oder mehr als einen Gasleitung 112g fluidleitend (gasleitend) verbunden sein, z.B. an der Stirnseite der Temperierrolle 112. Optional kann die Leitungsstruktur 120 mehrere von der Drehachse 111d weg und/oder radial erstreckte Rohrleitungen 120r (z.B. Schläuche) aufweisen, welche zumindest abschnittsweise außerhalb der Temperierrolle 112 verlaufen.

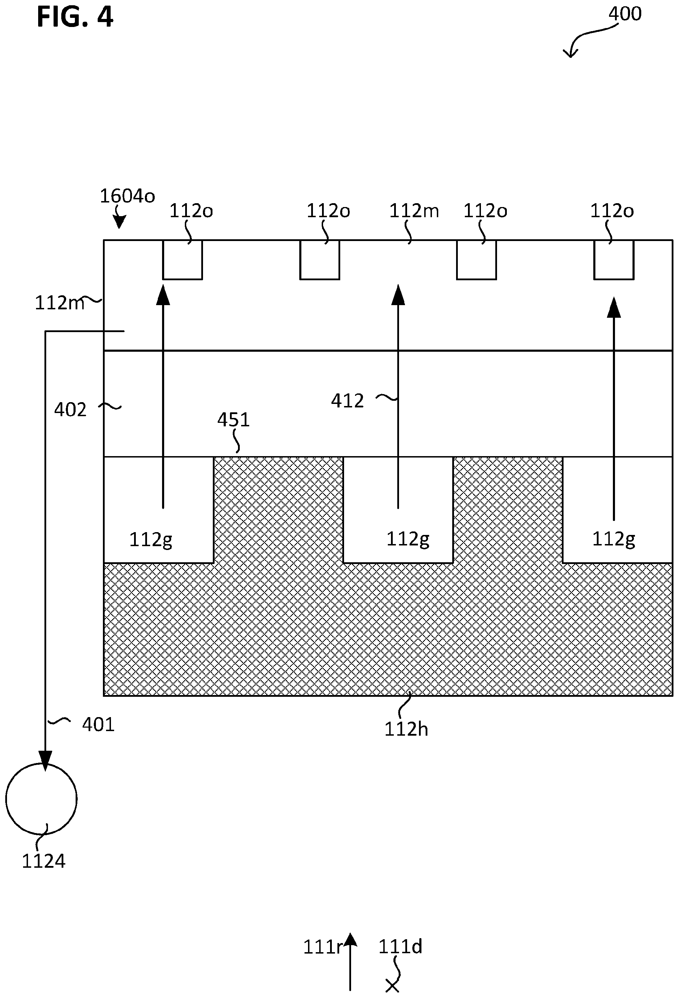

**Fig.4** veranschaulicht die Temperierrolle 112 gemäß verschiedenen Ausführungsformen in einer schematischen Querschnittsansicht 400 (z.B. mit Blick entlang der Drehachse 111d).

Die Temperierrolle 112 kann die zylinderförmige (z.B. hohlzylinderförmige) Rollenhülle 112m aufweisen, welche eine Vielzahl von Gasaustrittsöffnungen 112o aufweist. Die Kühlvorrichtung 1124 kann eingerichtet sein, der Rollenhülle 112m thermische Energie (auch als Wärme bezeichnet) zuzuführen und/oder zu entziehen. Beispielsweise kann die Kühlvorrichtung 1124 eingerichtet sein, Wärme von der Rollenhülle 112m weg nach außerhalb der Temperierrolle 112 zu transportieren oder andersherum.

Die Temperierrolle 112 kann ferner mehrere entlang der Drehachse 111d erstreckte Gasleitungen 112g aufweisen, welche beispielsweise in dem Rollengehäuse 112h gebildet sind und/oder sich in dieses hinein erstrecken.

Die Temperierrolle 112 kann ferner eine Gasverteilungsstruktur 402 aufweisen, welche die mehreren Gasleitungen 112g und die Vielzahl von Gasaustrittsöffnungen 112o gasleitend miteinander koppelt, so dass Gas 412 aus den Gasleitungen 112g durch die Gasverteilungsstruktur 402 hindurch zu der Vielzahl von Gasaustrittsöffnungen 112o strömen kann, an denen es aus der Temperierrolle 112 austreten kann.

Im Allgemeinen kann die Gasverteilungsstruktur 402 eine kleinere Strukturdichte (z.B. Strukturflächendichte) aufweisen als die Vielzahl von Gasaustrittsöffnungen 112o. Mit anderen Worten können sich die Gaskanäle der Temperierrolle 112 in eine radiale Richtung 111r zunehmend weiter verzweigen.

Die Strukturdichte kann auf gasleitende Hohlräume bezogen sein. Beispielsweise kann die Gasverteilungsstruktur 402 eine kleinere Hohlraumflächendichte aufweisen als die Rollenhülle 112m. Beispielsweise kann eine Flächendichte der Gasaustrittsöffnungen 112o größer sein als eine Flächendichte an Hohlräumen der Gasverteilungsstruktur 402. Alternativ oder zusätzlich zu der Strukturflächendichte, z.B. der Hohlraumflächendichte, kann dieselbe Relation auch für eine lineare Strukturdichte gelten.

Eine Flächendichte, z.B. die Strukturflächendichte (z.B. Hohlraumflächendichte), kann beispielsweise auf eine zylindermantelförmige Fläche der Drehachse 111d bezogen sein. Die lineare Dichte, z.B. lineare Strukturdichte, kann auf einen umfänglichen (in sich geschlossenen) Pfad quer zu der Drehachse 111d oder einen Pfad parallel zu der Drehachse 111d bezogen sein.

Beispielsweise kann die Gasverteilungsstruktur 402 von einer Vielzahl von (z.B. von der Drehachse 111d weg) erstreckter Gaskanäle (z.B. Durchbrüche oder Poren) durchdrungen sein, auf welche die Strukturflächendichte bezogen ist.

Gemäß verschiedenen Ausführungsformen kann die Gasverteilungsstruktur 402 eine oder mehr als eine Gasverteilungsschicht aufweisen, wie im Folgenden genauer beschrieben wird, z.B. eine oder mehr als eine der folgenden Gasverteilungsschichten: eine erste Gasverteilungsschicht 602, eine zweite Gasverteilungsschicht 702 und/oder eine dritte Gasverteilungsschicht 802.

Optional kann die Rollenhülle 112m porös sein, wie nachfolgend genauer beschrieben ist.

Optional kann zwischen der Gasverteilungsstruktur 402 und dem Rollengehäuse 112h eine Wärmeverteilungsschicht 451 angeordnet sein oder werden. Die Wärmeverteilungsschicht 451 kann beispielsweise Kupfer aufweisen oder daraus gebildet sein. Allgemeiner gesprochen kann die Wärmeverteilungsschicht 451 eine größere Wärmeleitfähigkeit aufweisen als die Gasverteilungsstruktur 402 und/oder das Rollengehäuse 112h. Beispielsweise kann das Rollengehäuse 112h Stahl aufweisen oder daraus gebildet sein.

Optional kann die Wärmeverteilungsschicht 451 auf das Rollengehäuse 112h aufgalvanisiert sein oder werden.

Bei Verwendung der Wärmeverteilungsschicht 451 (z.B. aus Kupfer) kann die Ableitung der Prozesswärme verbessert sein oder werden. Beispielsweise kann bei einer auf die Temperierrolle 112 und/oder das darüber transportierte Substrat eingebrachten Leistungsdichte von ungefähr 70 kW/m² eine zu niedrige Wärmeleitfähigkeit des Rollengehäuses 112h (z.B. ein Edelstahlmantel) zu einem Temperaturgradienten von ungefähr 50 K führen. Bei Verwendung der Wärmeverteilungsschicht 451 (z.B. aus hochwärmeleitfähigem Kupfer) ergibt sich bei gleicher Leistungsdichte nur noch ein Gradient von wenigen Kelvin (K).

Gemäß verschiedenen Ausführungsformen kann ein Walzenkörper 112h aus Edelstahl oder Baustahl mit einem Kupfermantel 451 bereitgestellt sein oder werden. Der Kupfermantel 451 kann beispielsweise aufgalvanisiert sein.

**Fig.5A** bis **5C** veranschaulicht einen porösen Körper 113 gemäß verschiedenen Ausführungsformen in einer schematischen Querschnittsansicht (z.B. mit Blick entlang der Drehachse 111d), z.B. die Rollenhülle 112m und/oder die erste Gasverteilungsschicht 602.

Fig.5A zeigt ein Netzwerk untereinander verbundenen Poren 704 (auch als Porennetzwerk bezeichnet), wobei das Porennetzwerk in einem Verbund (auch als Gefüge oder Aggregat bezeichnet) von Feststoffpartikeln 502 gebildet ist (zum Beispiel eine Schüttung und/oder Sinterung von Feststoffpartikeln). Die Poren 704 des Porennetzwerks können von den Zwischenräumen zwischen den Partikeln 502 gebildet sein. Die Feststoffpartikel 502 des Verbunds können in körperlichem Kontakt miteinander sein, z.B. zumindest paarweise. Die Feststoffpartikel 502 können miteinander verbunden sein, z.B. zusammengesintert, verklebt und/oder verschmolzen. Die Poren 704 des Porennetzwerks können miteinander verbunden sein und bilden daher eine Mehrzahl von gasleitenden Pfaden 502p (auch als Gaskanäle bezeichnet), die sich durch den Körper 113 hindurch erstrecken. Mit anderen Worten können die Poren 704 des Porennetzwerks entlang jedes Pfads der Vielzahl von Pfaden 502p miteinander verbunden sein (d.h. anschaulich ein Porennetzwerk bilden).

Das Porennetzwerk kann damit eine Vielzahl von Gaskanälen bereitstellen, welches an Oberfläche des Körpers 113 Öffnungen bilden (z.B. die Gasaustrittsöffnungen 112o) und/oder sich durch den Körper 113 hindurch erstrecken.

Fig.5B zeigt ein Porennetzwerk, welches in einem teilweise erodierten Material 706 des Körpers 113 gebildet sein kann. Das teilweise erodierte Material 706 kann eine Mehrzahl von Poren 704, z.B. teilweise längliche Poren, aufweisen, die beispielsweise miteinander verbunden sind.

Fig.5C zeigt ein Porennetzwerk, welches in einem festen Schaum 708 des Körpers 113 gebildet sein kann. Der feste Schaum 708 kann eine Vielzahl von Poren 704 einschließen.

Gemäß verschiedenen Ausführungsformen kann das Porennetzwerk mindestens eine der folgenden Porentypen aufweisen: Mikroporen, d.h., Poren 704 mit einer Ausdehnung 704e (z.B. Porendurchmesser) von weniger als etwa 2 nm; Mesoporen, d.h., Poren 704 mit einer Ausdehnung 704e im Bereich von etwa 2 nm bis etwa 50 nm; und/oder Makroporen, d.h., Poren 704 mit einer Ausdehnung 704e größer als etwa 50 nm. Die Ausdehnung einer Pore kann verstanden werden als der Durchmesser einer Kugel, welche dasselbe Volumen aufweist wie die Pore.

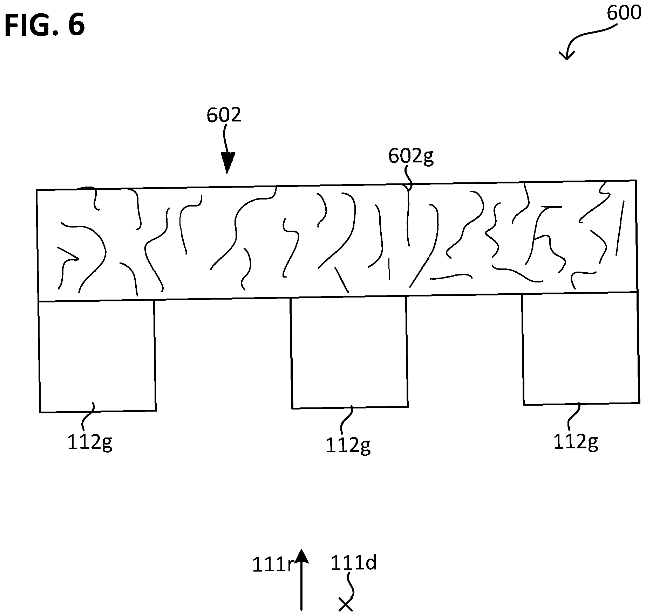

**Fig.6** veranschaulicht die Temperierrolle 112 gemäß verschiedenen Ausführungsformen in einer schematischen perspektivischen Querschnittsansicht 600 (z.B. mit Blick entlang der Drehachse 111d).

Die Gasverteilungsstruktur kann die erste Gasverteilungsschicht 602 aufweisen, welche eine poröse Schicht ist. Mit anderen Worten kann die Gasverteilungsschicht 602 eine Vielzahl von Gaskanälen 602g oder zu Gaskanälen verbundener Poren 602g aufweisen, auf welche die Strukturdichte bezogen ist.

Die erste Gasverteilungsschicht 602 kann eine kleinere räumliche Porendichte oder Porenflächendichte aufweisen als die Rollenhülle 112m. Optional kann die erste Gasverteilungsschicht 602 eine größere räumliche Porengröße aufweisen als die Rollenhülle 112m. Optional kann die erste Gasverteilungsschicht 602 eine größere Porosität aufweisen als die Rollenhülle 112m.

Optional kann die erste Gasverteilungsschicht 602 elektrisch leitfähig eingerichtet sein oder zumindest ein elektrisch leitfähiges Material aufweisen oder daraus gebildet sein. Elektrisch leitfähig kann hierin verstanden werden, als eine elektrische Leitfähigkeit von mehr als ungefähr 1 Siemens pro Meter (S/m) aufweisend, z.B. mehr als ungefähr 10³ S/m oder ungefähr 10⁵ S/m. Alternativ oder zusätzlich kann die erste Gasverteilungsschicht 602 ein Metall aufweisen oder daraus gebildet sein, z.B. Aluminium.

Alternativ oder zusätzlich kann die erste Gasverteilungsschicht 602 mehr als eine Vielfache (z.B. mehr als 10-fache, 100-fache oder 1000-fache) elektrische Leitfähigkeit aufweist als die Rollenhülle 112m.

Optional kann die Rollenhülle 112m einen Gradienten in der Porendichte aufweisen, wie später noch genauer beschrieben wird. Dann kann optional die erste Gasverteilungsschicht 602 weggelassen sein oder werden.

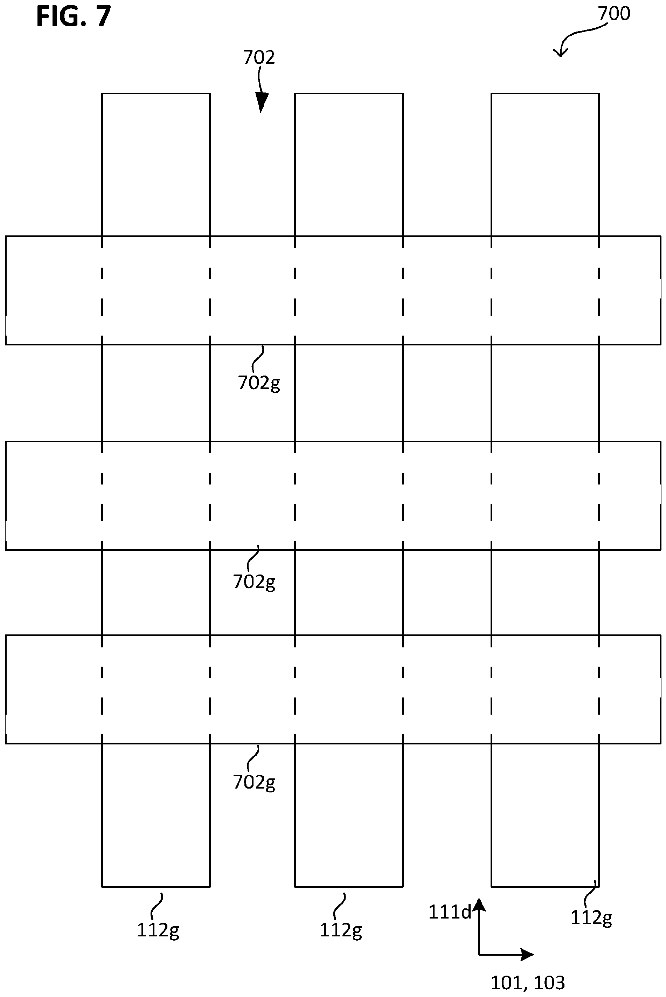

**Fig.7** veranschaulicht die Temperierrolle 112 gemäß verschiedenen Ausführungsformen in einer schematischen perspektivischen Querschnittsansicht 700 (z.B. entlang der zylinderförmigen Querschnittsfläche 101, 103 geschnitten).

Die zylinderförmige Querschnittsfläche 101, 103 kann die Drehachse 111d umgeben und senkrecht zu der radialen Richtung 111r sein, die quer zu der Drehachse 111d ist.

Die Gasverteilungsstruktur kann alternativ oder zusätzlich zu der ersten Gasverteilungsschicht 602 die zweite Gasverteilungsschicht 702 aufweisen.

Beispielsweise kann die zweite Gasverteilungsschicht 702 zwischen der ersten Gasverteilungsschicht 602 und den Gasleitungen 112g angeordnet sein.

Optional kann die zweite Gasverteilungsschicht 702 eine kleinere Strukturflächendichte aufweisen als die erste Gasverteilungsschicht 602 und/oder als die Rollenhülle 112m. Alternativ oder zusätzlich kann die zweite Gasverteilungsschicht 702 eine größere Strukturflächendichte aufweisen als die Vielzahl von Gasleitungen 112g.

Die zweite Gasverteilungsschicht 702 kann einen oder mehr als einen Gaskanal (auch als Umfangskanal 702g bezeichnet) aufweisen, welcher beispielsweise quer zu den mehreren Gasleitungen 112g erstreckt ist. Alternativ oder zusätzlich kann der oder jeder Umfangskanal 702g mehrere oder alle Gasleitungen 112g gasleitend miteinander verbinden.

Der oder jeder Umfangskanal 702g kann beispielsweise in dem Rollengehäuse gebildet sein und/oder sich in dieses hinein erstrecken.

Optional kann der oder jeder Umfangskanal 702g um die Drehachse herum längserstreckt sein, z.B. entlang einer Schraubenlinie (allgemeiner wendelförmig) oder entlang eines Kreisbogens. Optional kann der oder jeder wendelförmige Umfangskanal 702g mehrmals um die Drehachse herum längserstreckt sein. Alternativ kann der oder jeder kreisbogenförmige Umfangskanal 702g ungefähr 360° umspannen, z.B. entlang eines in sich geschlossenen Pfades erstreckt sein.

Optional können zwei einander unmittelbar benachbarte Umfangskanäle 702g miteinander verbunden sein, z.B. zu einer gemeinsamen Schraubenlinie.

Die zweite Gasverteilungsschicht 702 bzw. deren Umfangskanäle 702g können im Allgemeinen in verschiedenen Ausführungsformen auch weggelassen werden.

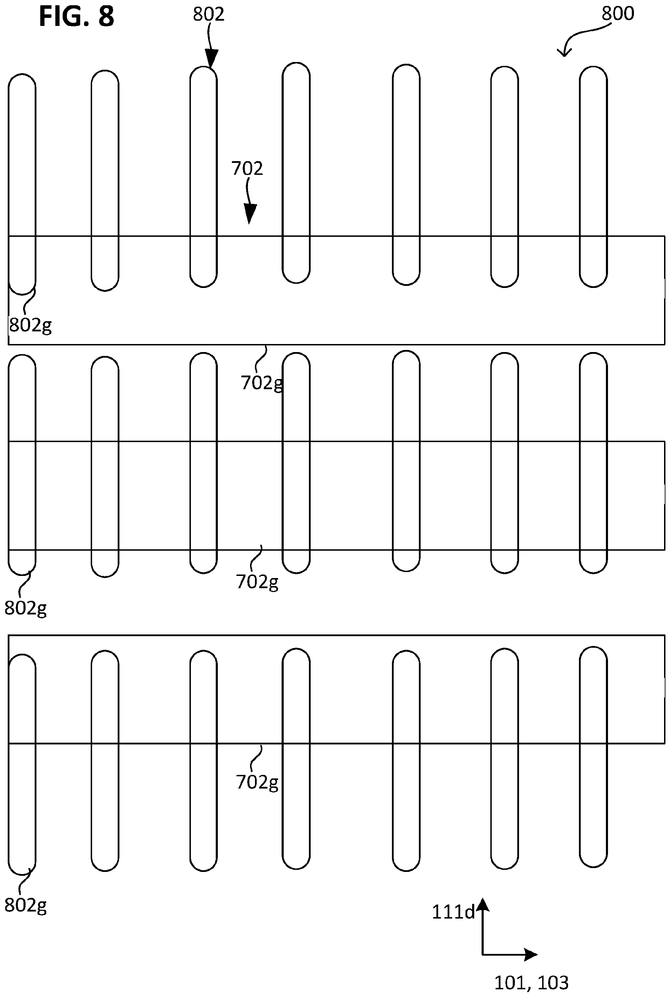

**Fig.8** veranschaulicht die Temperierrolle 112 gemäß verschiedenen Ausführungsformen in einer schematischen perspektivischen Querschnittsansicht 800 (z.B. entlang der zylinderförmigen Querschnittsfläche 101, 103 geschnitten).

Die Gasverteilungsstruktur kann alternativ oder zusätzlich zu der ersten Gasverteilungsschicht 602 oder zu der zweiten Gasverteilungsschicht 702 die dritte Gasverteilungsschicht 802 aufweisen.

Beispielsweise kann die dritte Gasverteilungsschicht 802 zwischen der Rollenhülle 112m (z.B. der ersten Gasverteilungsschicht 602) und den Gasleitungen 112g angeordnet sein. Beispielsweise kann die dritte Gasverteilungsschicht 802 zwischen der Rollenhülle 112m (z.B. der ersten Gasverteilungsschicht 602) und der zweiten Gasverteilungsschicht 702 angeordnet sein.

Optional kann die dritte Gasverteilungsschicht 802 eine kleinere Strukturflächendichte aufweisen als die erste Gasverteilungsschicht 702 und/oder als die Rollenhülle 112m. Alternativ oder zusätzlich kann die dritte Gasverteilungsschicht 802 eine größere Strukturflächendichte aufweisen als die Vielzahl von Gasleitungen 112g oder als die zweite Gasverteilungsschicht 702.

Die dritte Gasverteilungsschicht 802 kann eine oder mehr als eine Perforierung 802g (z.B. Ausstanzung) aufweisen, welcher beispielsweise entlang der Drehachse 111d längserstreckt ist. Beispielsweise kann die dritte Gasverteilungsschicht 802 mehrere Gruppen an Perforierungen 802g aufweisen, von denen alle Perforierungen 802g jeder Gruppe an denselben Umfangskanal 702g angrenzen.

Die oder jede Perforierung 802g kann sich entlang eines linearen Pfades durch die dritte Gasverteilungsschicht 802 hindurch erstrecken.

Beispielsweise kann die oder jede Perforierung 802g eine Ausdehnung entlang der Drehachse 111d (Längserstreckung) aufweisen, welche größer ist als eine dazu parallele Ausdehnung der oder jeder Umfangskanal 702g. Alternativ oder zusätzlich kann ein Abstand einander unmittelbar benachbarter Perforierungen 802g entlang der Drehachse 111d kleiner sein als ein dazu paralleler Abstand einander unmittelbar benachbarter Umfangskanäle 702g.

Beispielsweise kann ein Abstand einander unmittelbar benachbarter Perforierungen 802g quer zu der Drehachse 111d kleiner sein als eine dazu parallele Ausdehnung der Gasleitungen 112g.

Beispielsweise kann die oder jede Perforierung 802g als Langloch ausgebildet sein oder werden.

Die dritte Gasverteilungsschicht 802 kann im Allgemeinen in verschiedenen Ausführungsformen auch weggelassen werden.

Ist die dritte Gasverteilungsschicht 802 vorhanden, kann diese beispielsweise aufgeschrumpft sein oder werden. In diesem Fall kann die darunterliegende zweite Gasverteilungsschicht 702 bzw. der darunterliegende unterste Schicht 1402 glattgedreht und/oder poliert sein oder werden, z.B. feingeschlichtet sein.

Wird die dritte Gasverteilungsschicht 802 wegelassen, kann alternativ oder zusätzlich zu dieser optional eine poröse (z.B. thermisch aufgespritzte) Haftvermittlerschicht 802 verwendet werden. Die Haftvermittlerschicht 802 kann beispielsweise Nickel (Ni), Molybdän (Mo), Chrom (Cr), Yttrium (Y) und/oder Aluminium (Al) aufweisen, z.B. eine Legierung daraus, z.B. eine NiAl-Schicht, eine NiCr-Schicht, eine NiCrAlY-Schicht, und/oder eine Mo-Schicht. Die Haftvermittlerschicht kann auch auf dem glatten Untergrund gut haften.

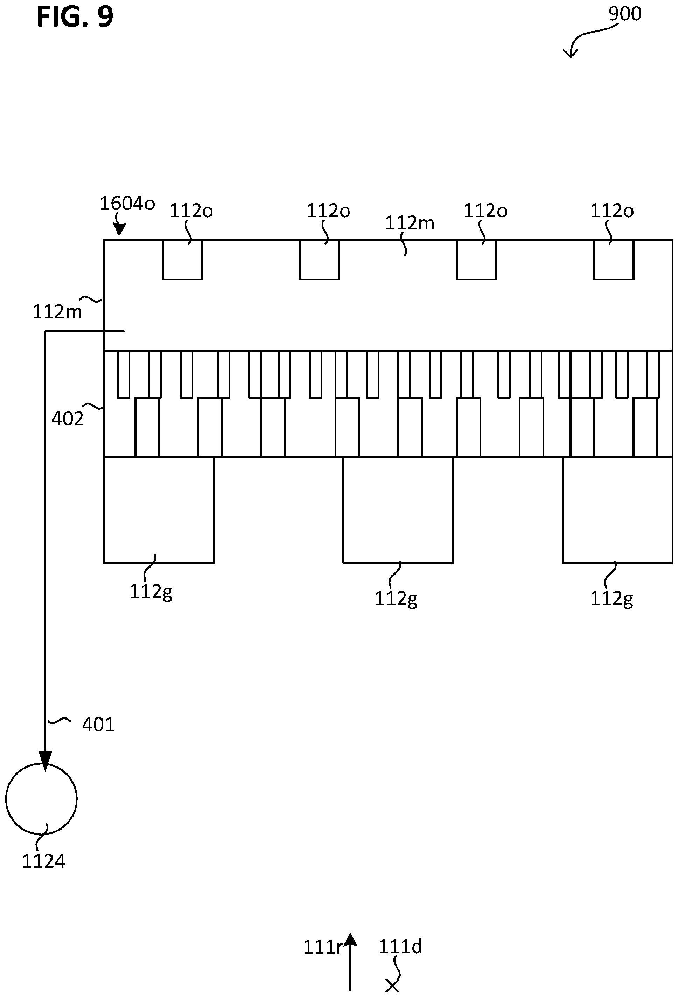

**Fig.9** veranschaulicht die Temperierrolle 112 gemäß verschiedenen Ausführungsformen in einer schematischen perspektivischen Querschnittsansicht 900 (z.B. mit Blick entlang der Drehachse 111d).

Gemäß verschiedenen Ausführungsformen kann die Strukturdichte der Gasverteilungsstruktur 402 in eine Richtung 111r von der Drehachse 111d weg (z.B. in radialer Richtung 111r) zunehmen.

Beispielsweise können die mehreren Gasverteilungsschichten 602, 702,802 der Gasverteilungsstruktur 402 sich in ihrer Strukturdichte voneinander unterscheiden (zum Beispiel paarweise). Alternativ oder zusätzlich kann diejenige Gasverteilungsschicht, welche einen größeren Abstand von der Drehachse 111d aufweist, als eine andere Gasverteilungsschicht, eine größere Strukturdichte aufweisen als die andere Gasverteilungsschicht.

Alternativ oder zusätzlich kann die Rollenhülle 112m einen Gradienten (z.B. entlang einer Richtung von der Drehachse weg) in der Strukturdichte aufweisen, z.B. einen Gradienten in der Porendichte. Der Gradient kann beispielsweise eine Richtung parallel zu der radialen Richtung 111r aufweisen. Beispielsweise können die Poren an der Temperierfläche 1604o der Rollenhülle 112m, welche die Vielzahl von Gasaustrittsöffnungen bereitstellen, die größte Porenflächendichte der Temperierrolle 112 aufweisen. Alternativ oder zusätzlich kann die Porenflächendichte der Rollenhülle 112m in Richtung zu der Drehachse 111d hin abnehmen.

Als Gradient in einem Parameter kann hierin verstanden werden, als dass der Parameter ein Gefälle (bzw. einen Anstieg) aufweist. Beispielsweise kann sich der Parameter entlang einer Strecke kontinuierlich und/oder stetig ändern, z.B. indem dieser entlang der Strecke jeden Wert zwischen den Werten an den Enden der Strecke genau einmal annimmt. Dies ist zu unterscheiden von dem Fall, in dem der Parameter einer Vielzahl diskreter Werte annimmt. Die Richtung des Gradienten bezeichnet dabei die Richtung des maximalen Gefälles.

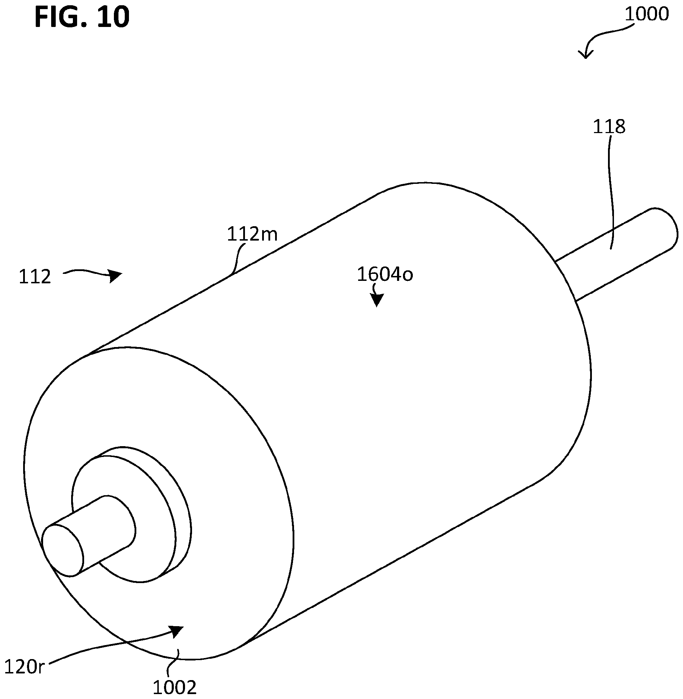

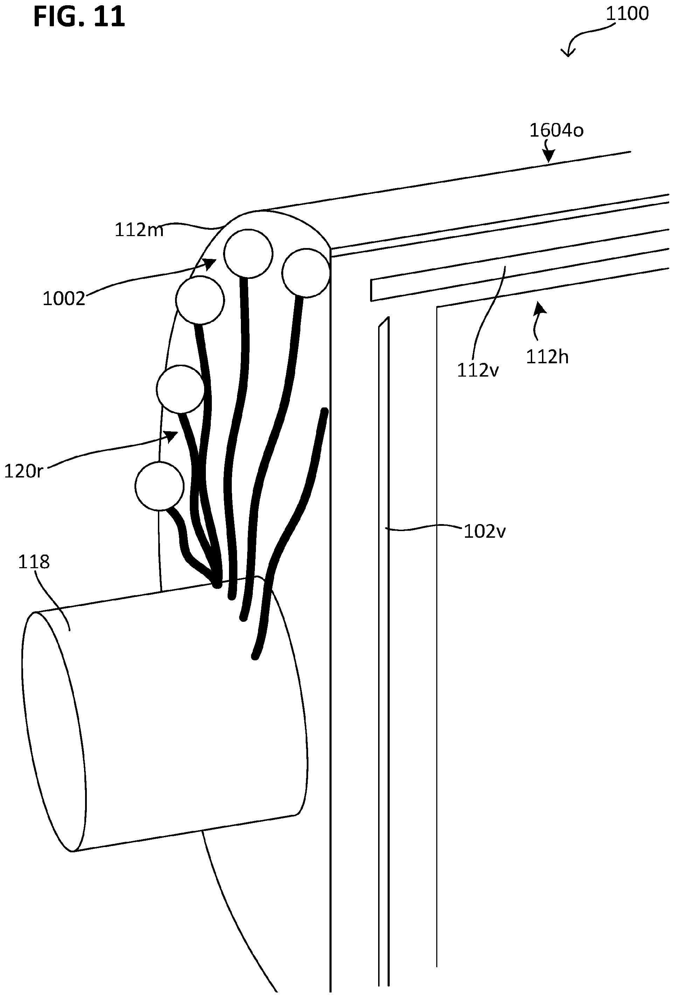

**Fig.10** veranschaulicht eine Transportanordnung 1000 gemäß verschiedenen Ausführungsformen in einer schematischen Perspektivansicht, z.B. die Transportanordnung 100 oder 200, und **Fig.11** diese in einer geschnittenen Perspektivansicht 1100.

Gemäß verschiedenen Ausführungsformen kann die Temperierrolle 112 mehrere Gasanschlüsse 1002 aufweisen, von denen jeder Gasanschluss 1002 mit genau einer Gasleitung 112g der mehreren Gasleitungen 112g gasleitend gekoppelt ist. Die mehrere Gasanschlüsse 1002 können beispielsweise mit den Rohrleitungen 120r gasleitend gekoppelt sein oder werden.

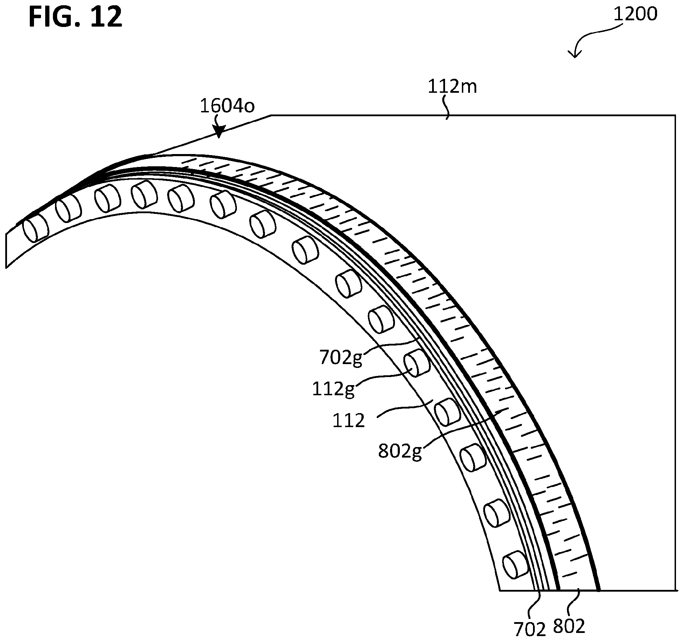

**Fig.12** veranschaulicht eine Transportanordnung 1200, z.B. die Transportanordnung 100, 200 oder 1000, gemäß verschiedenen Ausführungsformen in einer schematischen Perspektivansicht.

Die Perforierungen 802g können bereitgestellt sein, wie vorstehend beschrieben ist, z.B. mittels Durchbrüche in einer Platte, z.B. in einem Blech Die dritte Gasverteilungsschicht 802 weist eine Vielzahl von Filamenten auf, zwischen denen die Perforierungen 802g gebildet sind. Die Vielzahl von Filamenten bilden beispielsweise Maschen, welche jeweils eine Perforierung 802g umgeben. Die Filamente können beispielsweise Draht aufweisen oder daraus gebildet sein Die mehreren Filamente bilden ein Maschenwerk, z.B. in Form eines Gitters, Gestricks, eines Geflechts, eines Gewebes oder eines Netzes. Alternativ oder zusätzlich können die mehreren Filamente ein Metall aufweisen oder daraus gebildet sein, z.B. Stahl und/oder Kupfer. Beispielsweise kann die Gasverteilungsschicht 802 ein Metallgewebe, Metallgestrick und/oder ein Metallgeflecht aufweisen oder daraus gebildet sein, z.B. ein Kupfergewebe.

Beispielsweise kann das Maschenwerk (z.B. ein Gitter) mittels eines Siebgewebes bereitgestellt sein oder werden. Das Maschenwerk (z.B. dessen Filamente) kann beispielsweise Edelstahl aufweisen oder daraus gebildet sein. Für eine Kupferoberfläche (z.B. der Wärmeverteilungsschicht 451) kann beispielsweise das Maschenwerk auch mittels eines Kupfergewebes bereitgestellt sein oder werden. Alternativ oder zusätzlich kann das Maschenwerk (z.B. dessen Filamente) Aluminium aufweisen oder daraus gebildet sein. Dies verbessert die thermische Ankopplung.

Die Maschenweite des Maschenwerks kann beispielsweise in einem Bereich von ungefähr 0,5 mm bis ungefähr 1,5 mm sein, beispielsweise ungefähr 1,2 mm. Alternativ oder zusätzlich kann eine Dicke der Filamente (z.B. eine Drahtstärke) in einem Bereich von ungefähr 0,1 mm bis ungefähr 0,5 mm sein, z.B. ungefähr 0,2 mm. Die Dicke der Filamente kann deren Ausdehnung quer zu deren Längserstreckung sein.

Je größer die Maschenweite, desto besser kann die Gasleitfähigkeit sein, d.h. der Durchgriff und Verbund der Spritzschicht (allgemeiner Rollenhülle 112m) auf den Walzengrundkörper, und/oder desto schlechter kann die Nutüberbrückung sein. Je kleiner die Maschenweite ist, desto besser kann die Nutüberbrückung sein und/oder desto schlechter kann der Verbund der Spritzschicht mit dem Walzengrundkörper 112h und/oder der untersten Schicht 1402 sein. Ein besserer Verbund zwischen Walzengrundkörper 112h bzw. der untersten Schicht 1402 und Spritzschicht kann eine größere mechanische Stabilität und die Wärmeableitung bereitstellen.

Ein Ausgleich zwischen beiden Zuständen kann beispielsweise bei Maschenweiten in einem Bereich von ungefähr 0,8 mm bis ungefähr 1,2 mm sein. Die Drahtstärke kann beispielsweise möglichst gering gewählt werden, um die Störung aufgrund des Maschenwerks (z.B. Siebgewebes) im Schichtaufbau gering zu halten und einen guten Verbund zum Untergrund zu ermöglichen.

Die Applikation des Maschenwerks (z.B. Siebgewebes) auf dem Walzengrundkörper 112h und/oder der untersten Schicht 1402 kann auf verschiedene Weise erfolgen. Beispielsweise kann das Maschenwerk nur über die Nuten 112g, 702g darüber gelegt sein. Alternativ oder zusätzlich kann das Maschenwerk zumindest teilweise in den Nuten 112g, 702g angeordnet sein (auch als Einlage bezeichnet).

Beispielsweise kann der Walzengrundkörper 112h bzw. die unterste Schicht 1402 radial vollflächig mittels des Maschenwerks belegt werden (z.B. als Siebeinlage), da dort das Maschenwerk besser in der Fläche anliegt und eine homogene Störung in der Rollenhülle 112m (z.B. Spritzschicht) resultiert. Bei teilweiser Abdeckung (z.B. nur über oder in den Nuten 112g, 702g) kann eine größere Inhomogenität resultieren, da zusätzlich noch der Übergang zwischen Maschenwerk und freier Mantelfläche hinzukommt.

Ferner kann das Maschenwerk dann weniger am Walzengrundkörper anliegen und dadurch das Risiko der mangelhaften Schichtanbindung zum Grundkörper 112h bzw. der untersten Schicht 1402 steigen.

Die zweite Gasverteilungsschicht 702 bzw. deren Umfangskanäle 702g können beispielsweise auch weggelassen werden.

Die Befestigung des Maschenwerks auf einer Kupferoberfläche (z.B. der Wärmeverteilungsschicht 451) kann beispielsweise mittels einer Punktschweiß-Technologie erschwert sein. Daher kann in diesem Fall eine andere stoffschlüssige Verbindung hergestellt werden, z.B. mittels eines Klebers, z.B. mittels eines Polymerklebers, z.B. mittels eines Epoxidharzes oder eines 2-Komponenten-Klebstoffs.

Allgemeiner gesprochen kann die Gasverteilungsschicht 802 beispielsweise hemmen, dass die erste Gasverteilungsschicht 602 und/oder die Rollenhülle 112m beim Aufbringen in die Gasverteilungsschicht 702 bzw. deren Umfangskanäle 702g oder in die Gasleitungen 112g eindringt. Dieses Risiko des Eindringens kann beispielsweise erhöht sein, wenn die erste Gasverteilungsschicht 602 und/oder die Rollenhülle 112m mittels eines Spritzprozesses aufgebracht werden.

In dem Fall kann die Gasverteilungsschicht 802 auch anders bereitgestellt sein oder werden, z.B. mittels einer Einlage von mikrogeschlitzen und mikrogebogenen Blechstreifen in die Umfangskanäle 702g und/oder in die Gasleitungen 112g, mittels einer Einlage feiner Federstränge und/oder Metallgewebeschläuche in die in die Umfangskanäle 702g und/oder in die Gasleitungen 112g.

Mit anderen Worten kann die Gasverteilungsschicht 802 zumindest teilweise in den Umfangskanälen 702g und/oder in den Gasleitungen 112g angeordnet sein.

Weist die Gasverteilungsschicht 802 die mehreren Filamente, z.B. das Maschenwerk daraus, auf, kann die darunterliegende Oberfläche (z.B. der zweiten Gasverteilungsschicht 702) sanft raugestrahlt sein oder werden, z.B. bevor das Maschenwerk (z.B. das Siebgewebe) aufgelegt wird. Alternativ oder zusätzlich können mittels eines Drehprozess tangentiale Dreh-Spurrillen gebildet sein. Allgemeiner gesprochen kann die darunterliegende Oberfläche geschruppt oder geschlichtet sein.

Wird die Gasverteilungsschicht 802 aufgeschrumpft, kann es erforderlich sein, dass die darunterliegende besonders glatt (z.B. feingeschlichtet) ist, da eine hohe Oberflächengüte das Resultat des Aufschrumpfens der Gasverteilungsschicht 802 (z.B. eines Blechs) begünstigt. Weist die Gasverteilungsschicht 802 die mehreren Filamente auf, kann die Oberfläche hingegen rauer sein, z.B. geschruppt oder geschlichtet.

Eine geschruppte Oberfläche kann eine Rauheit in einem Bereich von ungefähr 3,2 µm (Mikrometer) bis ungefähr 25 µm aufweisen, z.B. fühlbare und mit dem Auge sichtbare Riefen. Eine geschlichtete Oberfläche kann eine Rauheit in einem Bereich von ungefähr 1,6 µm bis ungefähr 3,2 µm aufweisen, z.B. mit dem Auge noch sichtbare und/oder nicht fühlbare Riefen. Eine feingeschlichtete Oberfläche kann eine Rauheit in einem Bereich von ungefähr 0,8 µm bis ungefähr 1,6 µm aufweisen, z.B. keine mehr mit dem Auge sichtbare Riefen.

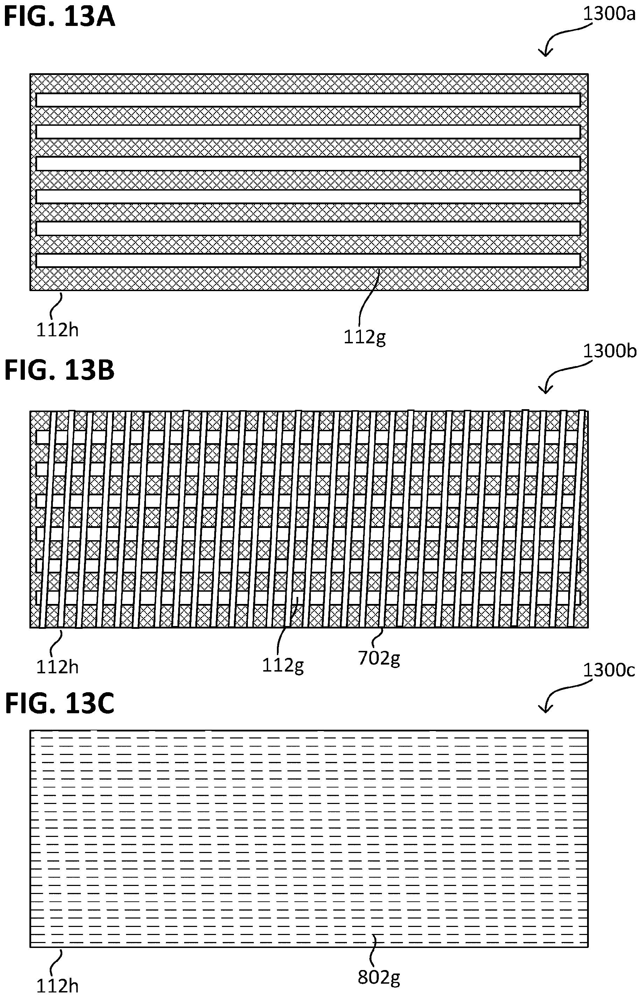

**Fig.13A** bis **13B** veranschaulichen jeweils eine Temperierrolle 112 in verschiedenen Ansichten gemäß verschiedenen Ausführungsformen.

In Ansicht 1300a ist die Vielzahl von Gasleitungen 112g veranschaulicht. Jede Gasleitungen 112g der Vielzahl von Gasleitungen 112g kann beispielsweise mittels einer Vertiefung in dem Rollengehäuse 112h bereitgestellt sein oder werden. In Ansicht 1300b ist die Vielzahl von Umfangskanälen 702g veranschaulicht. Jeder Umfangskanal 702g der Vielzahl von Umfangskanälen 702g kann beispielsweise mittels einer Vertiefung in dem Rollengehäuse 112h bereitgestellt sein oder werden und/oder die Gasleitungen 112g kreuzen.

In Ansicht 1300c ist die Vielzahl von Perforierungen 802g veranschaulicht. Jede Perforierung 802g der Vielzahl von Perforierungen 802g kann beispielsweise mittels eines Hohlzylinders über dem Rollengehäuse 112h bereitgestellt sein oder werden und/oder parallel zu den Gasleitungen 112g erstreckt sein, z.B. die Umfangskanäle 702g kreuzend.

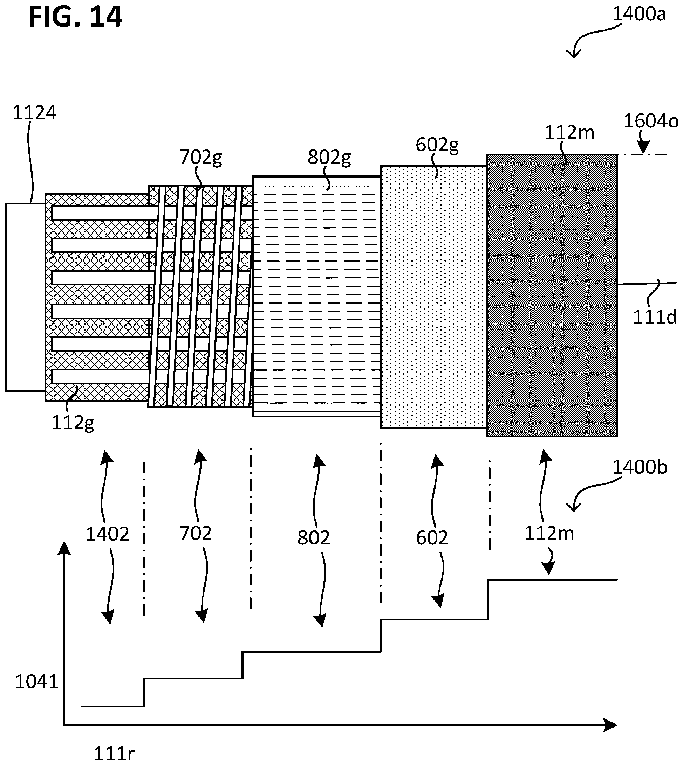

**Fig.14** veranschaulicht eine Temperierrolle 112 gemäß verschiedenen Ausführungsformen in einem schematischen Schichtaufbaudiagram 1400a und einem Strukturdichte-Diagramm 1400b, in welchem die Strukturdichte 1041 (z.B. die Porendichte) über dem Radius 111r aufgetragen ist. Die Schichten können beispielsweise als hohlzylinderförmige Schichten verstanden werden, welche bezüglich der Drehachse 111d übereinander angeordnet sein können, d.h. einen größer werdenden Radius 111r aufweisen. Die Schichten können beispielsweise einander paarweise berühren.

Im Inneren der Temperierrolle 112 kann die Kühlvorrichtung 1124 angeordnet sein. Die darüber liegende unterste Schicht 1402 kann die Vielzahl von Gasleitungen 112g aufweisen. Die darüber liegende zweite Gasverteilungsschicht 702 kann von einer Vielzahl von Umfangskanälen 702g und optional der Vielzahl von Gasleitungen 112g durchdrungen sein. Die darüber liegende dritte Gasverteilungsschicht 802 kann von einer Vielzahl von Perforierungen 802g durchdrungen sein. Die darüber liegende erste Gasverteilungsschicht 602 kann von einer Vielzahl von zu Gaskanälen 602g verbundenen Poren durchdrungen sein. Die darüber liegende Temperierfläche der Rollenhülle 112m kann die Vielzahl von Gasaustrittsöffnungen 112o aufweisen, welche die Rollenhülle 112m optional in Form einer Vielzahl von zu Gaskanälen verbundenen Poren durchdringt. Die Vielzahl von Gasaustrittsöffnungen 112o kann optional mittels der Vielzahl von zu Gaskanälen 602g verbundener Poren gebildet sein oder werden.

Beispielsweise kann die Rollenhülle 112m mikroporös sein und die erste Gasverteilungsschicht 602 kann mesoporös sein. Alternativ kann die Rollenhülle 112m mesoporös sein und die erste Gasverteilungsschicht 602 kann makroporös sein.

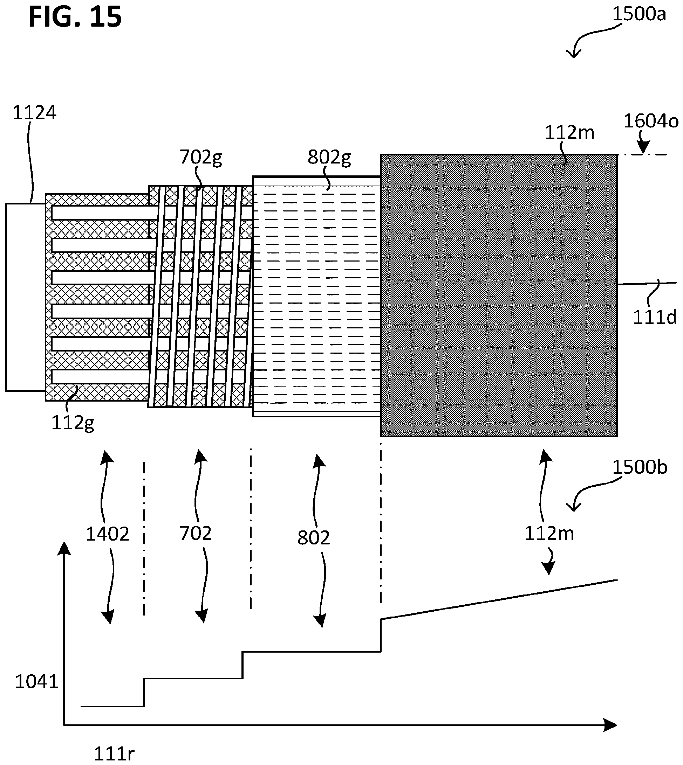

**Fig.15** veranschaulichen eine Temperierrolle 112 gemäß verschiedenen Ausführungsformen in einem schematischen Schichtaufbaudiagram 1500a und einem Strukturdichte-Diagramm 1500b, ähnlich zu Fig.14 mit dem Unterschied, dass die Rollenhülle 112m einen Gradienten in der Porendichte 1041 aufweist und optional die erste Gasverteilungsschicht 602 weggelassen ist. Im Unterschied zu den darunterliegenden Schichten kann die Rollenhülle 112m ein Gefälle in der Strukturdichte aufweisen, während die Strukturdichte der darunterliegenden Schichten beispielsweise diskrete Werte annimmt.

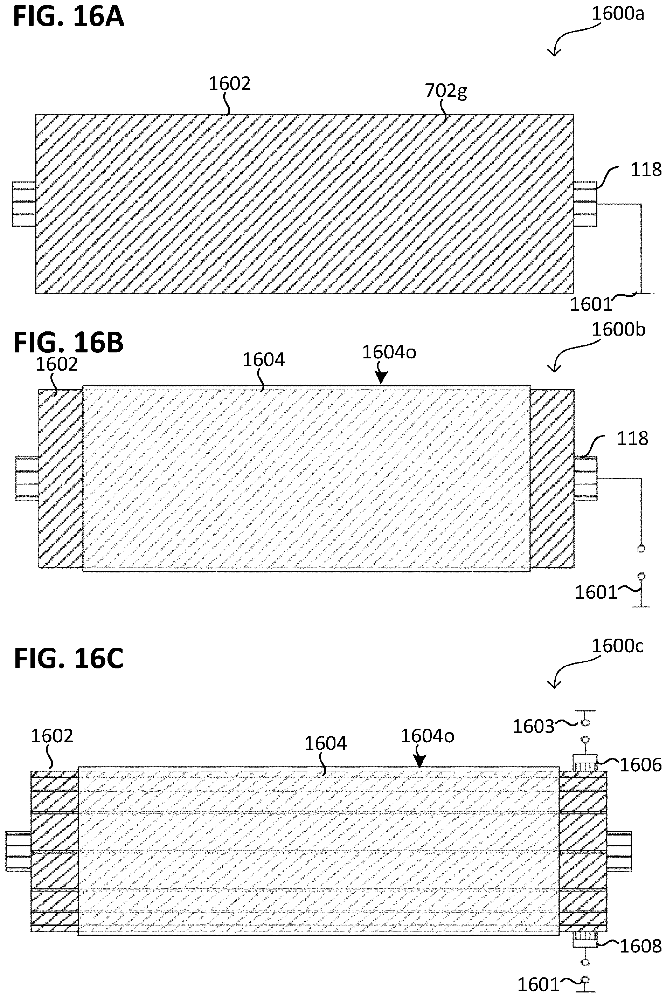

**Fig.16A** veranschaulichen eine Temperierrolle 112 gemäß verschiedenen Ausführungsformen in einem schematischen Schichtaufbaudiagram 1600a. Die Temperierrolle 112 kann eine oder mehr als eine elektrisch leitfähige (hohlzylinderförmige) Schicht 1602 (auch als Leitschicht 1602 bezeichnet) aufweisen. Die eine oder mehr als eine Leitschicht 1602 kann die unterste Schicht 1402 und/oder die zweite Gasverteilungsschicht 702 und/oder die dritte Gasverteilungsschicht 802 und/oder die erste Gasverteilungsschicht 602 aufweisen oder daraus gebildet sein.

Die eine oder mehr als eine Leitschicht 1602 kann beispielsweise die mehreren wendelförmigen Umfangskanäle 702g aufweisen.

In einem ersten Betriebsmodus (auch als Neutralmodus bezeichnet) kann an die eine oder mehr als eine Leitschicht 1602 ein Referenzpotential angelegt sein oder werden. Das Referenzpotential kann zum Beispiel elektrische Masse oder das elektrische Potenzial des Substrats sein. Das Referenzpotenzial kann alternativ oder zusätzlich an das Substrat angelegt sein oder werden. In dem ersten Betriebsmodus kann beispielsweise keine elektrostatische Anziehungskraft zwischen dem Substrat und der Temperierrolle 112 bereitgestellt sein oder werden.

**Fig.16B** veranschaulichen eine Temperierrolle 112 gemäß verschiedenen Ausführungsformen in einem schematischen Schichtaufbaudiagram 1600b.

Die Temperierrolle 112 kann eine oder mehr als eine elektrisch isolierende (zylindrische) Schicht 1604 (auch als Isolierschicht 1604 bezeichnet) aufweisen. Die Isolierschicht 1604 kann eine äußerste und freiliegende Schicht (auch als Abschlussschicht bezeichnet) der Temperierrolle sein und/oder die Temperierfläche aufweisen, z.B. die Rollenhülle 112m.

Beispielsweise kann eine Durchbruchspannung der Isolierschicht 1604 mehr als 1000 Volt (V) sein, z.B. mehr als ungefähr 2000 V, oder mehr als 3000 Volt (V).

Die eine oder mehr als eine Isolierschicht 1604 kann über der einen oder mehr als einen Leitschicht 1602 angeordnet sein. Die eine oder mehr als eine Isolierschicht 1604 kann eingerichtet sein, ein mittels der Temperierrolle 112 transportierte Substrat elektrisch (z.B. galvanisch) von der einen oder mehr als einen Leitschicht 1602 zu trennen.

Die eine oder mehr als eine Isolierschicht 1604 kann die Temperierfläche 1604o der Temperierrolle 112 aufweisen oder daraus gebildet sein. Die eine oder mehr als eine Isolierschicht 1604 kann beispielsweise die Rollenhülle 112m und optional die dritte Gasverteilungsschicht 802 und/oder optional die erste Gasverteilungsschicht 602 aufweisen.

In einem zweiten Betriebsmodus (auch als Anziehungsmodus bezeichnet) kann an die eine oder mehr als eine Leitschicht 1602 ein von dem Referenzpotential verschiedenes elektrisches Potential angelegt sein oder werden zum Beispiel mehr als 10 Volt (V), zum Beispiel mehr als 20 V, zum Beispiel mehr als 50 V, zum Beispiel mehr als 100 V. Die Spannungsangabe kann auf das Referenzpotential bezogen sein.

Das Referenzpotenzial kann alternativ oder zusätzlich an das Substrat angelegt sein oder werden.

In dem zweiten Betriebsmodus kann beispielsweise eine elektrostatische Anziehungskraft zwischen dem Substrat und der Temperierrolle 112 bereitgestellt sein oder werden oder zumindest eine größere elektrostatische Anziehungskraft als in dem ersten Betriebsmodus.

**Fig.16C** veranschaulichen eine Temperierrolle 112 gemäß verschiedenen Ausführungsformen in einem schematischen Schichtaufbaudiagram 1600c.

Die Temperierrolle 112 kann eingerichtet sein wie in 1600b, mit dem Unterschied, dass die Leitschicht 1602 mehrere galvanisch voneinander getrennte Segmente aufweist. Die Segmente der Leitschicht 1602 können beispielsweise entlang des Umfangs der Temperierrolle 112 nebeneinander angeordnet sein und oder sich entlang der Drehachse der Temperierrolle 112 längserstrecken.

Die Temperierrolle 112 kann ferner einen ersten elektrischen Kontakt 1606 aufweisen, welcher zumindest ein erstes Segment der Leitschicht 1602 elektrisch kontaktiert. Die Temperierrolle 112 kann ferner einen zweiten elektrischen Kontakt 1608 aufweisen, welcher entlang des Umfangs einen Abstand zu dem ersten elektrischen Kontakt 1606 aufweist und/oder zumindest ein zweites Segment der Leitschicht 1602 elektrisch kontaktiert.

Beispielsweise können der erste elektrische Kontakt 1606 und/oder der zweite elektrische Kontakt 1608 die Leitschicht 1602 körperlich kontaktieren und/oder auf einander gegenüberliegenden Seiten angeordnet sein.

In einem dritten Betriebsmodus (auch als Wechselmodus bezeichnet) kann an den ersten elektrischen Kontakt 1606 ein von dem Referenzpotential verschiedenes elektrisches Potential 1603 angelegt sein oder werden zum Beispiel mehr als 10 Volt (V), zum Beispiel mehr als 20 V, zum Beispiel mehr als 50 V, zum Beispiel mehr als 100 V. In dem dritten Betriebsmodus kann ferner an den zweiten elektrischen Kontakt 1606 das Referenzpotential 1601 angelegt sein oder werden oder zumindest das elektrische Potenzial des Substrats. Mit anderen Worten kann der erste elektrische Kontakt 1606 gemäß dem Anziehungsmodus und der zweite elektrische Kontakte 1608 gemäß dem Neutralmodus angesteuert sein oder werden.

Allgemeiner gesprochen können mehrere elektrische Kontakte 1606, 1608 bereitgestellt sein oder werden, von denen jeder Kontakt mit einem Segment der Temperierrolle elektrisch leitfähig verbunden ist.

Optional kann die Transportanordnung eine Steuervorrichtung aufweisen, welche ein an jedem Kontakt der mehreren elektrischen Kontakte 1606, 1608 anliegendes elektrisches Potential steuern und/oder regeln kann, z.B. separat voneinander. Damit kann die räumliche Verteilung der elektrostatischen Anziehungskraft des Substrats gesteuert und/oder geregelt werden. Das Steuern und/oder Regeln kann beispielsweise auf Grundlage eines Parameters erfolgen, welcher einen Gasdruck zwischen dem Substrat und der Temperierrolle 112 repräsentiert.

Der Wechselmodus kann beispielsweise aufweisen: Anlegen eines Referenzpotentiales an ein Substrat; Transportieren des Substrats mittels der Temperierrolle 112, wobei das Substrat mit einem ersten Abschnitt der Temperierrolle 112 vollständig in körperlichem Kontakt ist und mit einem zweiten Abschnitt der Temperierrolle 112 teilweise in körperlichem Kontakt ist (z.B. abgelöst wird); Anlegen des Referenzpotentiales an den zweiten Abschnitt und Anlegen eines von dem Referenzpotential verschiedenen elektrischen Potenziales an dem ersten Abschnitt, wobei das Referenzpotential einen kleineren Potentialunterschied zu dem Substrat aufweist als das von dem Referenzpotential verschiedene elektrische Potenzial.

Beispielsweise können der erste elektrische Kontakt 1606 und/oder der zweite elektrische Kontakt 1608 einen Schleifkontakt aufweisen, z.B. einen Bürstenkontakt.

Ein flexibles Substrat, wie beispielsweise eine Folie oder ein Band, kann mittels des körperlichen Kontaktes zu der Temperierrolle 112 (auch als Kühlwalze bezeichnet) gekühlt sein oder werden. Dabei kann der Wärmeübergang zwischen Substrat und Temperierrolle 112 (auch als Kühltrommel bezeichnet) die abführbare Wärmeleistung vergrößern. Beispielsweise kann der Wärmeübergang durch den Wärmetransport in einem Gaspolster zwischen Substrat und der Temperierrolle 112 anschaulich besonders hoch sein, wobei beispielsweise über 100 W/m²/K bis zu 1000 W/m²/K erreicht werden können. Der Wärmeübergang steigt mit steigendem Gasdruck des Gaspolsters zwischen dem Substrat und der Temperierrolle 112 und/oder mit Verringerung des Abstandes zwischen Substrat und Temperierrolle 112 an. Ein hoher Gasdruck zwischen Substrat und Temperierrolle 112 kann durch die Substratzufuhr (entweder aus dem Substrat selbst oder durch entsprechende Anreicherung auf der Substratoberfläche) aufrechterhalten werden. Beispielsweise kann das Gas durch die Temperierrolle 112 selbst hindurch in den Zwischenraum zwischen Substrat und Temperierrolle 112 eingebracht sein oder werden. Der Gasdruck zwischen dem Substrat und der Temperierrolle 112 kann beispielsweise im Maximum derart groß sein, dass er das Substrat nicht von der Temperierrolle 112 abhebt, wobei dem Anheben des Substrats der Anpressdruck, der beispielsweise durch den Bandzug aufgebaut wird, entgegenwirkt. Alternativ oder zusätzlich kann ein Substrat (z.B. eine Kunststofffolie) mittels elektrostatischer Anziehung an die Temperierrolle 112 gezogen werden, was insbesondere beim Elektronenstrahlverdampfen zum Einsatz kommen kann. Wird diese elektrostatische Anziehung allerdings zu groß eingestellt, kann das Ablösen des Substrats von der Temperierrolle 112 erschwert sein. Insbesondere bei der Nutzung von Elektronenstrahlen zum Verdampfen können verschiedene Vorrichtungen zum Entladen (auch als Entladungsvorrichtung bezeichnet) des Substrats verwendet werden, um einer beliebigen Aufladung des Substrats aufgrund des Beschichtungsprozesses mittels des Elektronenstrahls entgegenzuwirken. Mittels der Entladungsvorrichtung kann anschaulich die in das Substrat eingebrachte elektrische Ladung abgeführt werden, um beispielsweise das Substrat auf Referenzpotential zu bringen und/oder zu halten.

Beispielsweise kann eine Temperierrolle 112, welche eine metallische Temperierfläche 1604o aufweist (z.B. aus verchromten Stahl), keine oder nur ungenügend elektrostatische Anziehung bereitstellen, z.B. zu einer Metallfolie oder einer metallisch beschichteten Folie (wenn beispielsweise die beschichtete Seite an der Temperierrolle 112 anliegt), da dann die elektrische Aufladung abgeleitet und/oder abgeschirmt werden kann. Mittels der Leitschicht 1602 kann eine elektrostatische Kraft auf das Substrat bewirkt werden, welche das Substrat an die Temperierrolle 112 presst. Die elektrostatische Kraft kann anschaulich mittels einer vom Substrat isolierten Elektrode (die Leitschicht 1602) übertragen werden.

Gemäß verschiedenen Ausführungsformen kann für Anwendungen im Vakuum eine Temperierrolle 112 bereitgestellt sein oder werden, welche eine Gaskühlung und elektrostatische Anziehung kombiniert, wobei optional die Stärke der elektrostatischen Anziehung und/oder der Ort der elektrostatischen Anziehung gesteuert und/oder geregelt werden können.

Gemäß verschiedenen Ausführungsformen kann die Temperierrolle 112 an ihrer Temperierfläche 1604o perforiert bzw. diffusionsoffen sein, damit Gas aus der Temperierrolle 112 in den Zwischenraum zwischen Substrat und Temperierrolle 112 aus der Temperierrolle 112 heraus austreten kann. Die Temperierfläche 1604o der Temperierrolle 112 (z.B. eine äußere Oberfläche 1604o) kann beispielsweise aus einem elektrisch isolierenden Material hergestellt sein oder werden. Unter der elektrisch isolierten Temperierfläche 1604o der Temperierrolle 112 kann die Leitschicht 1602 angeordnet sein oder werden. Die Leitschicht 1602 kann entweder mittels der Welle 118 der Temperierrolle 112 (z.B. wenn die Temperierrolle 112 elektrisch isoliert gelagert ist) direkt auf ein vorgegebenes elektrisches Potenzial gebracht sein oder werden. Mit anderen Worten kann das elektrische Potential an der Welle 118 der Temperierrolle 112 eingekoppelt werden. Alternativ kann die Leitschicht 1602 gegenüber der Welle 118 der Temperierrolle 112 elektrisch isoliert sein oder werden, so dass das elektrische Potential direkt an der Leitschicht 1602 eingekoppelt werden kann.

Optional kann der Aufbau der Leitschicht 1602 und das Einkoppeln des elektrischen Potenzials in die Leitschicht 1602 derart eingerichtet sein oder werden, dass im Bereich des Wärmeeintrags (z.B. an dem Beschichtungsfenster) die höchste Anziehungskraft auf das Substrat übertragen wird und im Bereich der Ablösung des Substrats von der Temperierrolle 112 eine geringere Anziehungskraft auf das Substrat übertragen wird.

Damit kann erreicht werden, dass ein hoher Gasdruck bei gleichzeitig engem Spalt zwischen Substrat und der Temperierrolle 112 bereitgestellt werden kann und gleichzeitig in den Bereichen der Zu- und Abführung des Substrats eine verminderte Anziehung bereitgestellt wird, welche die Substratführung weniger beeinträchtigt.

Die elektrostatische Anziehungskraft wird beispielsweise mittels Anlegens einer Spannung zwischen dem Substrat und der Leitschicht 1602 bereitgestellt. Die gasdurchlässige und elektrisch isolierende äußere Schicht 1604 der Temperierrolle 112 kann beispielsweise eine Dicke von weniger als ungefähr 5 Millimeter (mm) aufweisen, z.B. von weniger als ungefähr 2,5 mm, z.B. von weniger als ungefähr 1 mm.

In einer ersten Konfiguration kann in dem Anziehungsmodus beispielsweise das Einkoppeln der elektrischen Spannung (z.B. bezüglich des Referenzpotentials) in die Leitschicht 1602 mittels des Rollengehäuses 112h und/oder der Welle 118 erfolgen.

Beispielsweise kann das Einkoppeln gesteuert und/oder geregelt erfolgen, so dass anschaulich ein Kompromiss zwischen einer möglichst hohen Anziehungskraft im Bereich des Beschichtungsfensters und einer ausreichenden Ablösekraft für das Ablösen des Substrats von der Temperierrolle 112 bereitgestellt wird.

Beispielsweise kann das Einkoppeln (z.B. der Wert der Spannung) gesteuert und/oder geregelt erfolgen auf Grundlage eines Parameters, welcher einen Arbeitspunkt repräsentiert, bei dem das Substrat prozessiert wird. Der Arbeitspunkt kann beispielsweise von der Ablösekraft definiert sein oder werden.

Beispielsweise kann die Ablösekraft erfasst werden und damit die für das Substrat maximal mögliche Anziehungskraft ermittelt werden. Die Anziehungskraft begrenzt anschaulich den maximal möglichen Gasdruck, der im Zwischenraum zwischen Substrat und der Temperierrolle 112 aufgebaut werden kann.

Für den Wechselmodus kann in einer zweiten Konfiguration die Leitschicht 1602 elektrisch isoliert gegenüber dem Rollengehäuse 112h und/oder der Welle 118 sein. Beispielsweise kann die Leitschicht 1602 derart aufgebracht sein oder werden, dass diese auf der Außenseite der Temperierrolle 112 kontaktiert werden kann (z.B. mit Graphitbürsten oder anderen Schleifkontakten). Durch eine elektrische Aufladung unmittelbar vor/im Beschichtungsfenster und einer elektrischen Entladung am Bereich des Substratablösens kann eine räumliche Verteilung der Anziehungskraft bereitgestellt werden. Die räumliche Verteilung des dazu korrespondierenden elektrischen Potentials, welches in die Leitschicht 1602 eingekoppelt wird, kann beispielsweise mittels der mehreren elektrischen Kontakte 1606, 1608 bereitgestellt sein oder werden.

Für den Wechselmodus kann optional die Leitschicht 1602 derart eingerichtet sein, dass die Leitschicht 1602 eine anisotrope elektrische Leitfähigkeit aufweist. Beispielsweise kann die elektrische Leitfähigkeit parallel zu der Drehachse 111d (auch als Querleitfähigkeit bezeichnet) größer sein als quer zu der Drehachse 111d, z.B. entlang der Transportrichtung. Die anisotrope elektrische Leitfähigkeit kann beispielsweise mittels Trennens der Leitschicht in Streifensegmente bereitgestellt sein oder werden.

Auf diese Weise kann in einem ersten Winkelbereich der Temperierrolle 112 eine erste Anziehungskraft auf das Substrat übertragen werden und in einem zweiten Winkelbereich eine zweite Anziehungskraft auf das Substrat übertragen werden, welche geringer ist als die erste Anziehungskraft. Die maximale erreichbare erste Anziehungskraft und damit beispielsweise der maximal mögliche Gasdruck im Zwischenraum zwischen der Temperierrolle 112 und dem Substrat können beispielsweise lediglich von der Durchbruchspannung (auch als Durchschlagspannungen bezeichnet) der Isolierschicht 1604 begrenzt sein. Das Ablöseverhalten ist in diesem Fall unabhängig davon, welcher Wert für die erste Anziehungskraft verwendet wird.

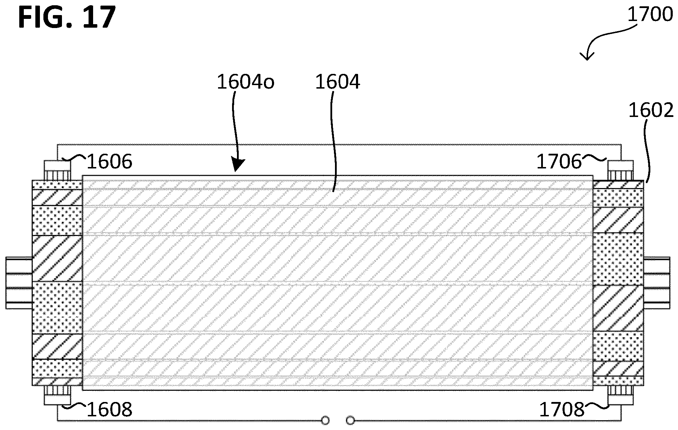

**Fig.17** veranschaulichen eine Temperierrolle 112 gemäß verschiedenen Ausführungsformen in einem schematischen Schichtaufbaudiagram 1700, welche beispielsweise eingerichtet ist wie in dem Schichtaufbaudiagram 1600c.

Für den Wechselmodus können in einer dritten Konfiguration der Leitschicht 1602 abwechselnd verschiedene elektrische Potenziale eingekoppelt sein oder werden, z.B. alternierend.

Beispielsweise können die erste Konfiguration und die zweite Konfiguration an ihre Grenze stoßen, wenn das Substrat nicht ausreichend geerdet ist oder eine Substraterdung auf das Prozessergebnis negative Auswirkungen hat. Um diese Grenze zu überwinden kann die Temperierrolle 112 derart kontaktiert sein oder werden, dass deren Segmente beim Drehen der Temperierrolle 112 wechselseitig auf einander gegenüberliegenden Seiten kontaktiert werden kontaktiert werden, z.B. mittels mehrerer Kontakte 1606, 1608, 1706, 1708, von denen ein oder mehr als ein erster Kontakt 1606, 1608 auf einer ersten Seite der Temperierrolle 112 und eine oder mehr als eine zweiter Kontakt 1706, 1708 auf einer der ersten Seite (entlang der Drehachse 111d) gegenüberliegenden zweiten Seite der Temperierrolle 112 angeordnet ist. Beispielsweise kann ein erstes Segment der Leitschicht 1602 auf der ersten Seite und ein zweites, dem ersten Segment unmittelbar benachbartes, Segment der Leitschicht 1602 auf der zweiten Seite elektrisch kontaktiert sein oder werden.

Die Segmente (z.B. Streifen) der Leitschicht 1602 können gegeneinander elektrisch isoliert, z.B. voneinander galvanisch getrennt, eingerichtet sein. Beispielsweise können diese in der gleichen Ebene voneinander getrennt sein oder in unterschiedlichen Ebenen mittels einer isolierenden Trennschicht voneinander separiert sein oder werden.

Neben einer Streifenform kann ein oder mehr als ein (z.B. jedes) Segment der Leitschichte 1602 auch anders geformt sein oder werden, z.B. mäanderförmig, keilförmig und/oder derart, dass die Temperierfläche 1604o maximal ausfüllt ist.

Analog zu der zweiten Konfiguration kann die Kontaktierung der Leitschicht 1602 an den Außenseiten der Temperierwalze 112, z.B. im Bereich des Beschichtungsfensters und in gleicher Weise der Ladungsausgleich (d.h. das Entladen der Leitschicht 1602) im Bereich der Substratzu- bzw. -abfuhr, erfolgen.

In einer vierten Konfiguration kann die Isolierschicht 1604 (z.B. eine äußere Isolationsschicht) aus einem Material hergestellt sein oder werden, welches einen leichten Austausch der Isolierschicht 1604 erlaubt. Beispielsweise kann die Isolierschicht 1604 perforierte Schrumpffolie, diffisionsoffenen Lack oder eine andere diffussionsoffene Beschichtung aufweisen, z.B. aufgedampftes ZrO (Zirkonoxid). Zur Wartung der Temperierrolle 112 kann beispielsweise eine Wartungsvorrichtung bereitgestellt sein oder werden, welche eine (z.B. gleichmäßige) Entfernung und nachfolgende Wiederaufbringung der Isolierschicht 1604 bereitstellt.

Mittels der hierin bereitgestellten Temperierrolle 112 kann eine Erhöhung und/oder Ermöglichung des Wärmeübergangs an der Temperierrolle 112 durch definiertes Anpressen mittels elektrostatischen Kräften und gleichzeitigem Gasstrom aus der der Temperierrolle 112 heraus in den Spalt zwischen Substrat und Temperierrolle 112 bereitgestellt sein oder werden.

**Fig.18** veranschaulicht eine Vakuumanordnung 1800 gemäß verschiedenen Ausführungsformen in einer schematischen Seitenansicht oder Querschnittsansicht (mit Blickrichtung entlang der Drehachse 111d), wobei die Vakuumanordnung 1800 die Transportanordnung 1200 oder alternativ eine der Transportanordnungen 100, 200, 300 oder 1000 aufweist, welche die Temperierrolle 112 aufweist.

Das Umwickeln und/oder Prozessieren (z.B. Beschichten) des Substrats 102 kann gemäß verschiedenen Ausführungsformen in einem Vakuum erfolgen, z.B. in einer Vakuumanordnung 1800.

Gemäß verschiedenen Ausführungsformen kann die Vakuumanordnung 1800 ein Vakuumkammergehäuse 802k aufweisen, in welcher ein Vakuum erzeugt und/oder erhalten werden kann. Das Vakuumkammergehäuse 802k kann dazu beispielsweise luftdicht, staubdicht und/oder vakuumdicht eingerichtet sein oder werden. Das Vakuumkammergehäuse 802k kann eine oder mehrere Vakuumkammern aufweisen. Die oder jede Vakuumkammer kann einen oder mehrere Vakuumbereiche 306b, 308b, z.B. Prozessierbereiche 306b, 308b, bereitstellen. Die mehreren Vakuumkammern und/oder die mehreren Vakuumbereiche 306b, 308b des Vakuumkammergehäuses 802k können optional zumindest teilweise gassepariert voneinander sein.

Ferner kann das Vakuumkammergehäuse 802k mit einem Pumpensystem 804 (aufweisend zumindest eine Grobvakuumpumpe und optional zumindest eine Hochvakuumpumpe) gekoppelt sein. Das Pumpensystem 804 kann eingerichtet sein, dem Vakuumkammergehäuse 802k ein Gas (z.B. das Prozessgas) zu entziehen, so dass innerhalb des Vakuumkammergehäuses 802k ein Vakuum (d.h. ein Druck kleiner als 0,3 bar) und/oder ein Druck in einem Bereich von ungefähr 1 mbar bis ungefähr 10⁻³ mbar (mit anderen Worten Feinvakuum) und/oder ein Druck in einem Bereich von ungefähr 10⁻³ mbar bis ungefähr 10⁻⁷ mbar (mit anderen Worten Hochvakuum) oder ein Druck von kleiner als Hochvakuum, z.B. kleiner als ungefähr 10⁻⁷ mbar (mit anderen Worten Ultrahochvakuum) bereitgestellt sein oder werden kann.

Das Pumpensystem 804 kann beispielsweise die Pumpenanordnung 1716 aufweisen oder daraus gebildet sein. Alternativ oder zusätzlich kann die Vakuumanordnung 1800 eine Gaszuführungsanordnung 1716 aufweisen. Mittels der Gaszuführungsanordnung 1716 kann dem Vakuumkammergehäuse 802k ein Prozessgas zugeführt werden zum Bilden einer Prozessatmosphäre in dem Vakuumkammergehäuse 802k. Das Prozessgas kann z.B. ein Inertgas aufweisen oder daraus gebildet sein. Alternativ oder zusätzlich kann das Prozessgas ein Reaktivgas aufweisen oder daraus gebildet sein, z.B. Sauerstoff, Stickstoff, Wasserstoff, Argon und/oder Kohlenstoff. Der Prozessdruck kann sich aus einem Gleichgewicht an Prozessgas bilden, welches mittels der Gaszuführungsanordnung 1716 zugeführt und mittels des Pumpensystems 804 entzogen wird.

Ferner kann das Vakuumkammergehäuse 802k derart eingerichtet sein, dass der Arbeitspunkt (z.B. die Vakuumbedingungen oder allgemeiner die Prozessbedingungen), bei denen das Substrat prozessiert wird (z.B. Prozessdruck, Prozesstemperatur, chemische Prozessgaszusammensetzung, elektrostatische Anziehungskraft, usw.) gestellt oder geregelt werden können (z.B. lokal), z.B. mittels einer Steuervorrichtung 508. Beispielsweise können mittels des Vakuumkammergehäuses 802k mehrere Vakuumbereiche 306b, 308b mit voneinander verschiedenen Arbeitspunkten bereitgestellt sein oder werden. Beispielsweise kann die Steuervorrichtung 508 zum Steuern und/oder Regeln einer Spannungsversorgung 806, der Gaszuführungsanordnung 1716 und/oder des Pumpensystems 804 eingerichtet sein. Mittels der Spannungsversorgung 806 kann beispielsweise der Temperierrolle 112 (z.B. Gasverteilungsstruktur 402) ein elektrisches Potential bereitgestellt sein oder werden. Beispielsweise kann die Steuervorrichtung 508 zum Steuern und/oder Regeln des der Temperierrolle 112 (z.B. der Gasverteilungsstruktur 402) eingekoppelten elektrischen Potentials und/oder der daraus resultierenden Anziehungskraft, welche auf das Substrat 102 übertragen wird, eingerichtet sein. Alternativ oder zusätzlich kann die Steuervorrichtung 508 zum Steuern und/oder Regeln eines Normvolumenstroms an Prozessgas eingerichtet sein, welche mittels der Gaszuführungsanordnung 1716 und/oder der Temperierrolle 112 zugeführt und/oder mittels des Pumpensystems 804 entzogen wird.

Gemäß verschiedenen Ausführungsformen kann die Steuervorrichtung 508 zum Steuern und/oder Regeln einer optionalen Temperiervorrichtung 1124 (z.B. aufweisend eine Heizvorrichtung und/oder ein Kühlvorrichtung) eingerichtet sein, so dass eine Prozesstemperatur (z.B. des Substrat 102 und/oder des Prozessgases), beispielsweise während des Prozessierens (z.B. während des Beschichtens), gesteuert und/oder geregelt werden kann. Beispielsweise kann die Steuervorrichtung 508 eingerichtet sein zum Steuern und/oder Regeln einer thermischen Leistung, welche mittels der Substrat-Temperiervorrichtung 1124 zugeführt und/oder mittels dieser entzogen wird.

Optional kann die Vakuumanordnung 1800 eine Versorgungsvorrichtung zum Versorgen der Temperiervorrichtung 1124 aufweisen, z.B. zum Versorgen mit einem temperierten Fluid (z.B. einer Kühlflüssigkeit) oder mit elektrischer Energie. Beispielsweise kann die Versorgungsvorrichtung außerhalb der Prozessierkammer 802k angeordnet sein. Beispielsweise kann ein Heiz- oder ein Kühlmedium zu der Temperiervorrichtung 1124 (z.B. der Temperierrolle 112) zu- und von dieser wieder abgeführt werden.

In dem Vakuumkammergehäuse 802k (z.B. in einer ersten Vakuumkammer) kann zumindest ein Vakuumbereich 306b, 308b, z.B. ein erster Vakuumbereich 306b, angeordnet sein. Ferner kann in dem Vakuumkammergehäuse 802k (z.B. in der ersten Vakuumkammer) eine erste Prozessierquelle 306, z.B. eine Beschichtungsmaterialquelle 306, angeordnet sein. Die Beschichtungsmaterialquelle 306 kann zum Emittieren eines gasförmigen Beschichtungsmaterials in den ersten Vakuumbereich 306b hinein eingerichtet sein. Mit dem Beschichtungsmaterial kann das Substrat 102 beschichtet sein oder werden. Mit anderen Worten kann das Beschichten des Substrats 102 in dem ersten Vakuumbereich 306b erfolgen. Der erste Vakuumbereich 306b kann ein Beschichtungsbereich 306b sein.

In dem Vakuumkammergehäuse 802k (z.B. in einer zweiten Vakuumkammer oder in der ersten Vakuumkammer) kann optional zumindest ein zweiter Vakuumbereich 308b angeordnet sein. Ferner kann in dem Vakuumkammergehäuse 802k (z.B. in der zweiten Vakuumkammer) eine zweite Prozessierquelle 308, z.B. eine Belichtungsvorrichtung 308, angeordnet sein. Die zweite Prozessierquelle 308 kann beispielsweise zum Bearbeiten und/oder Beschichten des Beschichtungsmaterials eingerichtet sein, mit dem das Substrats 102 beschichtet ist oder wird.

Gemäß verschiedenen Ausführungsformen kann das Vakuumkammergehäuse 802k eine Kammeröffnung zum Freilegen des Inneren des Vakuumkammergehäuses 802k aufweisen. Die Kammeröffnung kann das Innere des Vakuumkammergehäuses 802k beispielsweise in Drehachsenrichtung 111d freilegen. Zum Verschließen der Kammeröffnung kann das Vakuumkammergehäuse 802k einen Kammerdeckel aufweisen.

Gemäß verschiedenen Ausführungsformen kann die Steuervorrichtung 508 zum Steuern und/oder Regeln der ersten Prozessierquelle 306 und/oder der zweiten zweite Prozessierquelle 308 eingerichtet sein, z.B. indem diese eine Materialmenge und/oder thermische Energie (z.B. Strahlungsenergie) steuert und/oder regeln welche pro Zeit in Richtung 105 des Substrats 102 emittiert wird.

Ferner kann die Vakuumanordnung 1800 eine oder mehr als eine Temperierrolle 112 (z.B. Gaskühlrolle 112) und optional eine oder mehr als eine Führungsrolle 122 aufweisen, welche einen Transportpfad 111 definieren, entlang dessen das Substrat 102 (z.B. ein bandförmiges Substrat) zwischen der Abwickelwalze 112a, 112b und der Aufwickelwalze 112b durch den zumindest einen Vakuumbereich 306b, 308b hindurch transportiert wird, z.B. in eine Transportrichtung 111w (welche senkrecht zu der Drehachse 111d sein kann). Die Führungsrolle 122 kann eingerichtet sein, den Transportpfad umzulenken.

Optional kann ein Reinigen der Temperierrolle 112 erfolgen, indem eine Verunreinigung (z.B. ein parasitär abgeschiedenes Metall) von der Rollenhülle 112m abgetragen (mittels Zerstäubens) wird, z.B. mittels einer Sputtervorrichtung. Optional kann die Sputtervorrichtung bereitgestellt sein oder werden, indem die Temperierrolle 112 als Sputterkathode eingerichtet wird. Dazu kann an die Temperierrolle 112, z.B. deren Leitschicht 1602 ein elektrisches Sputterpotential angelegt werden, mittels dessen ein Plasma erzeugt werden kann. Mit anderen Worten kann das Plasma mit elektrischer Energie versorgt werden, welche mittels der Temperierrolle 112 zugeführt wird. Weist die Vakuumanordnung 1800 keine Sputtervorrichtung auf, kann eine der Prozessierquellen (z.B. deren Verdampfungstiegel) gegen die Sputtervorrichtung ausgetauscht werden.

Zum Sputtern kann mittels der Sputterkathode ein plasmabildendes Gas ionisiert werden, wobei mittels des dabei gebildeten Plasmas ein Material (z.B. Verunreinigungen) von der Temperierrolle 112 abgetragen (z.B. zerstäubt) werden kann. Das zerstäubte Material kann anschließend aus der Vakuumkammer herausgebracht werden. Zerstäubtes Material setzt sich auf gegebenenfalls während der Reinigung bereitliegenden Substraten oder in der Prozessumgebung (Blecheinbauten) ab. Mittels Sputterns kann beispielsweise eine Schicht oder können mehrere Schichten von der Temperierrolle 112 abgetragen werden. Alternativ oder zusätzlich kann mittels Sputterns die Rollenhülle 112m der Temperierrolle 112 (z.B. deren Poren) freigelegt werden. Alternativ oder zusätzlich kann mittels Sputterns eine Strukturdichte der Temperierrolle 112 (z.B. deren Rollenhülle 112m) vergrößert werden, z.B. indem verstopfte Poren geöffnet werden.

Im Folgenden werden verschiedene Beispiele beschrieben, die sich auf vorangehend Beschriebene und in den Figuren Dargestellte beziehen.

Beispiel 1 ist eine Temperierrolle unter anderem aufweisend: eine zylinderförmige (z.B. hohlzylinderförmige) Rollenhülle, welche eine Vielzahl von Gasaustrittsöffnungen aufweist; eine Temperiervorrichtung (z.B. Kühlvorrichtung), welche eingerichtet ist, der Rollenhülle thermische Energie zuzuführen und/oder zu entziehen; mehrere entlang der Drehachse erstreckte Gasleitungen; eine Gasverteilungsstruktur, welche die mehreren Gasleitungen und die Vielzahl von Gasaustrittsöffnungen gasleitend miteinander koppelt, wobei die Gasverteilungsstruktur eine kleinere Strukturdichte und/oder größere elektrische Leitfähigkeit aufweist als die Rollenhülle, wobei optional die Gasverteilungsstruktur mittels der Rollenhülle elektrisch isoliert (z.B. galvanisch getrennt) wird (z.B. in eine radiale Richtung und/oder von einem auf der Temperierrolle aufliegendem Substrat), die Temperierrolle optional ferner aufweisend: eine Wärmeverteilungsschicht, welche zwischen der Gasverteilungsstruktur und den mehreren Gasleitungen angeordnet ist, wobei die Wärmeverteilungsschicht eine größere Wärmeleitfähigkeit aufweist als die Gasverteilungsstruktur und/oder ein Material der Temperierrolle, in welchem die mehreren Gasleitungen gebildet sind, wobei die Wärmeverteilungsschicht beispielsweise Kupfer aufweist oder daraus gebildet ist.

Beispiel 2 ist die Temperierrolle gemäß Beispiel 1, wobei die Gasverteilungsstruktur die Vielzahl von Gasaustrittsöffnungen gasleitend untereinander koppelt, und/oder wobei die Gasverteilungsstruktur die mehreren Gasleitungen gasleitend untereinander koppelt.

Beispiel 3 ist die Temperierrolle gemäß Beispiel 1 oder 2, wobei die Strukturdichte auf eine zylindrische (z.B. zylindermantelförmige) Fläche und/oder auf gasleitfähige Öffnungen bezogen (d.h. die Gasleitungsstrukturdichte) ist, z.B. auf gashindurchleitfähige Öffnungen.

Beispiel 4 ist die Temperierrolle gemäß einem der Beispiele 1 bis 3, wobei die Gasaustrittsöffnungen mittels einer Vielzahl von untereinander verbundenen Poren bereitgestellt sind, auf welche die Strukturdichte bezogen ist.

Beispiel 5 ist die Temperierrolle gemäß einem der Beispiele 1 bis 4, wobei die Strukturdichte der Rollenhülle auf die Flächendichte der Gasaustrittsöffnungen bezogen ist.

Beispiel 6 ist die Temperierrolle gemäß einem der Beispiele 1 bis 5, wobei die Gasverteilungsstruktur eine (z.B. hohlzylinderförmige) poröse Schicht aufweist, auf welche (z.B. deren Porenflächendichte) die Strukturdichte der Gasverteilungsstruktur bezogen ist und/oder welche mit der Rollenhülle körperlich in Kontakt ist.

Beispiel 7 ist die Temperierrolle gemäß Beispiel 6, wobei die Strukturdichte eine Porenflächendichte ist.

Beispiel 8 ist die Temperierrolle gemäß Beispiel 6 oder 7, wobei sich die poröse Schicht und die Vielzahl von Gasaustrittsöffnungen (z.B. das Netzwerk von untereinander verbundenen Poren) in zumindest einer von folgenden Eigenschaften unterscheiden: einer räumlichen Porendichte; einer räumlichen Porengröße; und/oder einer Porosität.

Beispiel 9 ist die Temperierrolle gemäß einem der Beispiele 6 bis 8, wobei die poröse Schicht elektrisch leitfähig eingerichtet ist oder zumindest ein elektrisch leitfähiges Material aufweist oder daraus gebildet ist.

Beispiel 10 ist die Temperierrolle gemäß einem der Beispiele 1 bis 9, wobei die Gasverteilungsstruktur (z.B. deren poröse Schicht) eine größere elektrische Leitfähigkeit aufweist als die Rollenhülle.

Beispiel 11 ist die Temperierrolle gemäß einem der Beispiele 1 bis 10, wobei die Gasverteilungsstruktur mehrere (z.B. hohlzylinderförmige) Schichten aufweist, welche sich in ihrer Strukturdichte unterscheiden.

Beispiel 12 ist die Temperierrolle gemäß einem der Beispiele 1 bis 11, wobei die Gasverteilungsstruktur mehrere Umfangskanäle aufweist, von denen jeder Umfangskanal die mehreren Gasleitungen gasleitend untereinander koppelt und/oder auf welche die Strukturdichte bezogen ist.

Beispiel 13 ist die Temperierrolle gemäß Beispiel 12, wobei von den mehreren Umfangskanälen jeder Umfangskanal um die Drehachse herum längserstreckt ist.

Beispiel 14 ist die Temperierrolle gemäß Beispiel 12 oder 13, wobei von den mehreren Umfangskanälen ein oder mehr als ein Umfangskanal entlang eines Kreisbogens erstreckt ist.

Beispiel 15 ist die Temperierrolle gemäß einem der Beispiele 12 bis 14, wobei die mehrere Gasleitungen und die mehreren Umfangskanäle einander kreuzen und/oder schräg zueinander verlaufen.

Beispiel 16 ist die Temperierrolle gemäß einem der Beispiele 12 bis 15, wobei von den mehreren Umfangskanälen jeder Umfangskanal mit allen Gasleitungen der mehreren Gasleitungen gasleitend gekoppelt ist.

Beispiel 17 ist die Temperierrolle gemäß einem der Beispiele 12 bis 16, wobei von den mehreren Umfangskanälen ein oder mehr als ein Umfangskanal entlang einer Helix erstreckt ist.

Beispiel 18 ist die Temperierrolle gemäß Beispiel 17, wobei von den mehreren Umfangskanälen aneinandergrenzende Umfangskanäle entlang einer gemeinsamen Helix erstreckt sind.

Beispiel 19 ist die Temperierrolle gemäß einem der Beispiele 1 bis 18, wobei die Gasverteilungsstruktur eine Gasverteilungsschicht (z.B. eine Platte, z.B. ein Blech und/oder eine Lochplatte) aufweist, welche von einer Vielzahl von Perforierungen (z.B. Langlöchern oder Schlitzen) durchdrungen ist, auf welche die Strukturdichte bezogen ist; wobei beispielsweise die Gasverteilungsschicht (z.B. ein Maschenwerk) eine Vielzahl von Filamenten aufweist, zwischen denen die Vielzahl von Perforierungen bereitgestellt ist, wobei die Gasverteilungsschicht beispielsweise zumindest teilweise (d.h. teilweise oder vollständig) innerhalb der mehreren Umfangskanälen und/oder mehreren Gasleitungen angeordnet ist, wobei die Gasverteilungsstruktur alternativ oder zusätzlich zu der Gasverteilungsschicht eine Haftvermittlungsschicht aufweist, wobei beispielsweise die Haftvermittlungsschicht granular und/oder porös ist, wobei beispielsweise die Haftvermittlungsschicht Nickel und/oder Aluminium aufweist oder daraus gebildet ist.

Beispiel 20 ist die Temperierrolle gemäß einem der Beispiele 1 bis 19, wobei die zylinderförmige Rollenhülle ein Netzwerk von untereinander verbundenen Poren aufweist, welches die Vielzahl von Gasaustrittsöffnungen bereitstellt; wobei die Gasverteilungsstruktur eine größere Strukturdichte aufweist als das Netzwerk von untereinander verbundenen Poren.

Beispiel 21 ist die Temperierrolle gemäß einem der Beispiele 1 bis 20, wobei die Rollenhülle (z.B. entlang einer Richtung quer zu der Drehachse) einen Gradienten in der Strukturdichte aufweist.

Beispiel 22 ist die Temperierrolle gemäß einem der Beispiele 1 bis 21, wobei die Rollenhülle (z.B. entlang einer Richtung quer zu der Drehachse) einen Gradienten aufweist in zumindest einer von folgenden Eigenschaften: einer räumlichen Porendichte; einer räumlichen Porengröße; und/oder einer Porosität.

Beispiel 23 ist die Temperierrolle gemäß einem der Beispiele 1 bis 22, wobei die Gasverteilungsstruktur eine größere Strukturdichte aufweist als die mehreren Gasleitungen.

Beispiel 24 ist die Temperierrolle gemäß einem der Beispiele 1 bis 23, wobei die Gasverteilungsstruktur eine größere lineare Strukturdichte entlang der Drehachse aufweist als die mehreren Gasleitungen.

Beispiel 25 ist die Temperierrolle gemäß einem der Beispiele 1 bis 24, wobei die Gasverteilungsstruktur eine kleinere lineare Strukturdichte entlang der Drehachse aufweist als die Vielzahl von Gasaustrittsöffnungen.

Beispiel 26 ist die Temperierrolle gemäß einem der Beispiele 1 bis 25, wobei die Gasverteilungsstruktur eine größere lineare Strukturdichte quer zu der Drehachse (z.B. in eine umfängliche Richtung) aufweist als die Vielzahl von Gasaustrittsöffnungen.

Beispiel 27 ist die Temperierrolle gemäß einem der Beispiele 1 bis 26, ferner aufweisend: mehrere Gasanschlüsse, von denen jeder Gasanschluss mit genau einer Gasleitung der mehreren Gasleitungen gasleitend gekoppelt ist.

Beispiel 28 ist die Temperierrolle gemäß einem der Beispiele 1 bis 27, die Temperiervorrichtung aufweisend: ein zylinderförmiges (und z.B. doppelwandiges) Gehäuse, welches einen Hohlraum aufweist (z.B. mittels einer doppelwandigen Gehäusewand bereitgestellt) zum Aufnehmen eines Temperierfluides (z.B. Kühlfluides), wobei die Gasverteilungsstruktur beispielsweise zwischen dem Gehäuse und der Rollenhülle angeordnet ist.

Beispiel 29 ist die Temperierrolle gemäß einem der Beispiele 1 bis 28, die Temperiervorrichtung ferner aufweisend: einen Temperierfluidanschluss zum Anschließen an eine Temperierfluidversorgung (z.B. Kühlfluidversorgung).

Beispiel 30 ist die Temperierrolle gemäß einem der Beispiele 1 bis 29, wobei die Rollenhülle elektrisch isolierend eingerichtet ist oder zumindest ein elektrisch isolierendes Material (z.B. ein Dielektrikum) aufweist oder daraus gebildet ist.

Beispiel 31 ist die Temperierrolle gemäß einem der Beispiele 1 bis 30, wobei die Rollenhülle eine elektrische Durchbruchspannung von mehr als 1000 Volt (V) bereitstellt.

Beispiel 32 ist die Temperierrolle gemäß einem der Beispiele 1 bis 31, ferner aufweisend: eine Kontaktierungsanordnung, welche elektrisch leitfähig mit der Gasverteilungsstruktur verbunden ist zum Einkoppeln eines elektrischen Potentials in die Gasverteilungsstruktur.

Beispiel 33 ist die Temperierrolle gemäß einem der Beispiele 1 bis 32, wobei die Gasverteilungsstruktur mehrere elektrisch voneinander isolierte Segmente aufweist, welche elektrisch leitfähig sind.

Beispiel 34 ist die Temperierrolle gemäß einem der Beispiele 1 bis 33, wobei die Gasverteilungsstruktur eine anisotrope elektrische Leitfähigkeit aufweist.

Beispiel 35 ist die Temperierrolle gemäß Beispiel 34, wobei die Kontaktierungsanordnung mehrere elektrische Kontakte aufweist, wobei zumindest zwei Kontakt der mehreren elektrischen Kontakte auf einander gegenüberliegenden Seiten der Temperierrolle angeordnet sind; und/oder wobei zumindest zwei Kontakt der mehreren elektrischen Kontakte einen Abstand voneinander aufweisen, der größer ist als eine dazu parallele Ausdehnung der Segmente der Gasverteilungsstruktur.

Beispiel 36 ist die Temperierrolle gemäß Beispiel 35, wobei sich die zumindest zwei Kontakte in dem Segment unterscheiden, mit dem diese elektrisch leitfähig gekoppelt sind.

Beispiel 37 ist die Temperierrolle gemäß einem der Beispiele 1 bis 36, ferner aufweisend: eine Spannungsquelle, welche eingerichtet ist, der Gasverteilungsstruktur ein elektrisches Potential einzukoppeln.

Beispiel 38 ist die Temperierrolle gemäß Beispiel 37, wobei die Spannungsquelle ein Steuervorrichtung aufweist, die eingerichtet ist, das elektrische Potential zu steuern und/oder zu regeln, z.B. auf Grundlage eines Parameters, welcher einen Arbeitspunkt repräsentiert, bei dem ein Substrat prozessiert wird, wobei die Steuervorrichtung beispielsweise eingerichtet ist, eine räumliche Verteilung des elektrischen Potentials zu steuern und/oder zu regeln .

Beispiel 39 ist die Temperierrolle gemäß Beispiel 38, wobei der Parameter zumindest eine der folgenden Arbeitspunk-Parameter aufweist oder diese repräsentiert: einen Gasdruck zwischen dem Substrat und der Temperierrolle; eine Kraft, welche zum Ablösen des Substrats von der Temperierrolle erforderlich ist (auch als Ablösekraft bezeichnet); eine Temperatur des Substrats.

Beispiel 40 ist die Temperierrolle gemäß einem der Beispiele 1 bis 39, wobei die Rollenhülle und/oder die Gasverteilungsstruktur (z.B. deren poröse Schicht) eine Vielzahl von Feststoffpartikeln (z.B. ein granulares Material) aufweisen.

Beispiel 41 ist die Temperierrolle gemäß einem der Beispiele 1 bis 40, wobei die Gasverteilungsstruktur (z.B. deren poröse Schicht und/oder Feststoffpartikel) ein Metall (z.B. Aluminium) aufweist oder daraus gebildet ist.

Beispiel 42 ist die Temperierrolle gemäß einem der Beispiele 1 bis 41, wobei die Strukturdichte der Rollenhülle (z.B. entlang des Umfangs und/oder der Drehachse) in einem Bereich von 200 mm ungefähr bis ungefähr 2000 mm (oder mehr) ist; und/oder wobei die Strukturdichte der ersten Gasverteilungsschicht (z.B. entlang des Umfangs und/oder der Drehachse) in einem Bereich von 10 mm ungefähr bis ungefähr 100 mm ist, und/oder wobei die Strukturdichte (z.B. entlang der Drehachse) der Umfangskanäle in einem Bereich von 0,1 mm ungefähr bis ungefähr 0,5 mm (z.B. 0,25 mm) ist, und/oder wobei die Strukturdichte der Perforierungen in einem Bereich von 0,05 mm ungefähr bis ungefähr 0,3 mm ist, und/oder wobei die Strukturdichte der Gasleitungen (z.B. entlang des Umfangs) in einem Bereich von 0,01 mm ungefähr bis ungefähr 0,05 mm ist. Beispielsweise kann das Walzenaußenrohr eine umfänglich umlaufende Nut (z.B. ähnlich einer Gewindenut), welche die Umfangskanäle bereitstellt, aufweisen, beispielsweise mit einer Steigung von ungefähr 5 mm oder mehr, einer Tiefe von ungefähr 1 mm, und/oder einem Flankenwinkel von ungefähr 60°. Alternativ oder zusätzlich kann das Walzenaußenrohr mehrere in axialer Richtung (d.h. entlang der Drehachse) erstreckte Nuten aufweisen, welche die Gasleitungen bereitstellen, z.B. mit einer Breite (Ausdehnung quer zur Drehachse entlang des Umfangs) von ungefähr 4 mm und/oder einer Tiefe von ungefähr 6 mm, oder ungefähr 40 Stück (oder zwischen ungefähr 20 und ungefähr 80) über den Umfang der Temperierrolle verteilt, z.B. äquidistant zueinander und/oder alle 9°. Beispielsweise kann eine perforierte Hülle auf dem Walzenaußenrohr angeordnet (z.B. übergestülpt) sein, welche eine Vielzahl Schlitze (z.B. eine Schlitzanordnung), die die Perforierungen bereitstellen, aufweist, wobei von dieser jeder Schlitz beispielsweise eine Länge in axialer Richtung von ungefähr 10 mm und eine Breite quer dazu von ungefähr 0,3 mm aufweisen kann, einander unmittelbar benachbarte Schlitze einen Abstand in axialer Richtung und/oder entlang des Umfangs von ungefähr 7 mm aufweisen können, und/oder einander unmittelbar benachbarte Schlitze (z.B. in axial erstreckten Reihen angeordnet, d.h. unmittelbar aufeinanderfolgende Schlitzreihen) versetzt zueinander angeordnet sind, z.B. jeweils um ungefähr 8,5 mm (anschaulich (10 mm Länge + 7 mm Abstand) / 2 = 8,5 mm). Beispielsweise kann eine mikroporöse Beschichtung, welche eine Grundschicht, die die erste Gasverteilungsschicht bereitstellt, und/oder eine Deckschicht, welche die Rollenhülle bereitstellt, aufgebracht sein oder werden. Beispielsweise kann die Grundschicht eine Dicke von ungefähr 2 mm aufweisen, Aluminium aufweisen oder daraus gebildet sein, und/oder eine Porosität in einem Bereich von ungefähr 5% bis ungefähr 25% (z.B. ungefähr 10 %) aufweisen. Beispielsweise kann die Deckschicht eine Dicke von ungefähr 0,5 mm oder zumindest von weniger die Grundschicht aufweisen. Beispielsweise kann die Deckschicht ein oder mehr als ein Oxid aufweisen oder daraus gebildet sein (z.B. Aluminiumoxid (z.B. Al₂O₃), Chromxid, Titanoxid, Yttriumoxid, und/oder Zirkonoxid (z.B. ZrO)).

Beispiel 43 ist die Temperierrolle gemäß einem der Beispiele 1 bis 42, wobei die Rollenhülle (z.B. deren poröse Schicht und/oder Feststoffpartikel) eine Keramik (z.B. Zirkonoxid oder Aluminiumoxid) aufweist oder daraus gebildet ist.

Beispiel 44 ist eine Temperierrolle, z.B. die Temperierrolle gemäß einem der Beispiele 1 bis 43, aufweisend: eine zylinderförmige Rollenhülle, welche eine Drehachse definiert und ein Netzwerk von untereinander verbundenen Poren aufweist, welche eine Vielzahl von Gasaustrittsöffnungen bereitstellen; eine Gasverteilungsstruktur, welche einen Gasanschluss zum Anschließen einer Gasversorgung aufweist; eine Temperiervorrichtung (z.B. Kühlvorrichtung), welche eingerichtet ist, der zylinderförmigen Rollenhülle thermische Energie zuzuführen und/oder zu entziehen; wobei die Gasverteilungsstruktur mehrere quer zur Drehachse verlaufende Umfangskanäle aufweist, welche eine gasleitende Verbindung zwischen den mehrere Gasaustrittsöffnungen und dem Gasanschluss bereitstellen oder zumindest Teil dieser Verbindung sind, und von denen jeder Umfangskanal um die Drehachse herum längserstreckt ist; wobei die Gasverteilungsstruktur ferner eine poröse Schicht aufweist, welche eine gasleitende Verbindung zwischen der Vielzahl von Gasaustrittsöffnungen und dem Gasanschluss bereitstellt oder zumindest Teil der gasleitenden Verbindung ist; wobei sich die poröse Schicht und das Netzwerk von untereinander verbundenen Poren in zumindest einer von folgenden Eigenschaften unterscheiden: einer räumlichen Porendichte; einer räumlichen Porengröße; und/oder einer Porosität.

Beispiel 45 ist die Temperierrolle, z.B. die Temperierrolle gemäß einem der Beispiele 1 bis 44, aufweisend: eine zylinderförmige Rollenhülle, welche eine Drehachse definiert und ein Netzwerk von untereinander verbundenen Poren, welche eine Vielzahl von Gasaustrittsöffnungen bereitstellen, aufweist; eine Gasverteilungsstruktur, welche einen Gasanschluss zum Anschließen einer Gasversorgung aufweist; eine Temperiervorrichtung (z.B. Kühlvorrichtung), welche eingerichtet ist, der zylinderförmigen Rollenhülle thermische Energie zuzuführen und/oder zu entziehen; wobei die Gasverteilungsstruktur eine poröse Schicht aufweist, welche eine gasleitende Verbindung zwischen der Vielzahl von Gasaustrittsöffnungen und dem Gasanschluss bereitstellt oder zumindest Teil dieser Verbindung ist; wobei sich die poröse Schicht und das Netzwerk von untereinander verbundenen Poren in zumindest einer von folgenden Eigenschaften unterscheiden: einer räumlichen Porendichte; einer räumlichen Porengröße; und/oder einer Porosität.

Beispiel 46 ist die Temperierrolle, z.B. die Temperierrolle gemäß einem der Beispiele 1 bis 45, aufweisend: eine zylinderförmige Rollenhülle, welche eine Drehachse definiert und ein Netzwerk von untereinander verbundenen Poren aufweist, die eine Vielzahl von Gasaustrittsöffnungen bereitstellen; eine Gasverteilungsstruktur, welche einen Gasanschluss zum Anschließen einer Gasversorgung aufweist; eine Temperiervorrichtung (Kühlvorrichtung), welche eingerichtet ist, der zylinderförmigen Rollenhülle thermische Energie zuzuführen und/oder zu entziehen; wobei das Netzwerk von untereinander verbundener Poren (z.B. entlang einer Richtung quer zu der Drehachse) einen Gradienten aufweist in zumindest einer von folgenden Eigenschaften: einer räumlichen Porendichte; einer räumlichen Porengröße; und/oder einer Porosität.

Beispiel 47 ist die Temperierrolle, z.B. die Temperierrolle gemäß einem der Beispiele 1 bis 46, aufweisend: eine zylinderförmige Rollenhülle, welche eine Drehachse definiert und eine Vielzahl von Gasaustrittsöffnungen aufweist; eine Gasverteilungsstruktur, welche einen Gasanschluss zum Anschließen einer Gasversorgung aufweist; eine Temperiervorrichtung (z.B. Kühlvorrichtung), welche eingerichtet ist, der zylinderförmigen Rollenhülle thermische Energie zuzuführen und/oder zu entziehen; wobei die Gasverteilungsstruktur ferner mehrere Umfangskanäle aufweist, welche eine gasleitende Verbindung der mehreren Gasaustrittsöffnungen zu dem Gasanschluss bereitstellen oder zumindest Teil dieser Verbindung sind, und von denen jeder Umfangskanal entlang eines (z.B. in sich geschlossenen oder wendelförmigen) Pfades um die Drehachse herum längserstreckt ist.

Beispiel 48 ist eine Transportanordnung, aufweisend: eine Temperierrolle gemäß einem der Beispiele 1 bis 47, zwei Umwickelrollen (z.B. eine Abwickelwalze und eine Aufwickelwalze), welche eingerichtet sind, zwischen diesen ein Substrat umzuwickeln; mehrere optionale Transportrollen 122, welche gemeinsam mit der Temperierrolle einen Transportpfad zwischen den zwei Umwickelrollen zum Umwickeln des Substrats entlang des Transportpfades bereitstellen.

Beispiel 49 ist eine Vakuumanordnung, aufweisend: eine Transportanordnung gemäß Beispiel 48, eine Prozessierquelle zum Prozessieren (z.B. eine Beschichtungsmaterialquelle zum Beschichten) eines mittels der Temperierrolle transportierten Substrats.

Beispiel 50 ist die Vakuumanordnung gemäß Beispiel 49, ferner aufweisend: eine Vakuumkammer, in welcher die Temperierrolle angeordnet ist.

Beispiel 51 ist ein Verfahren, aufweisend: Umwickeln eines Substrats mittels einer Temperierrolle, z.B. der Temperierrolle gemäß einem der Beispiele 1 bis 50; Einbringen eines Gases zwischen die Temperierrolle und das Substrat; Bereitstellen einer elektrischen Spannung zwischen der Temperierrolle und dem Substrat zum Übertragen einer elektrostatischen Anziehungskraft auf das Substrat; optionales Emittieren eines Beschichtungsmaterials in Richtung der Temperierrolle zum Beschichten des Substrats mit dem Beschichtungsmaterial; optionales Steuern und/oder Regeln der elektrischen Spannung, z.B. auf Grundlage eines Parameters, welcher einen Arbeitspunkt repräsentiert, bei dem ein Substrat prozessiert wird; wobei optional die elektrischen Spannung räumlich inhomogen verteilt wird; optionales Entziehen und/oder Zuführen von thermischer Energie von bzw. zu dem Substrat mittels der Temperierrolle.

Beispiel 52 ist ein Verfahren unter anderem aufweisend: Einrichten der Temperierrolle als Sputterkathode, z.B. Einkoppeln eines elektrischen Sputterpotentials (z.B. zum Erzeugen eines elektrischen Wechselfeldes) in die Temperierrolle; Erzeugen eines Plasmas mittels der Sputterkathode; und Zerstäuben eines Materials (z.B. eines metallischen Materials) von Temperierrolle mittels des Plasmas, z.B. zum Reinigen der Temperierrolle; optionales Austauschen einer Prozessiervorrichtung, wobei das Austauschen beispielsweise aufweist, einen Verdampfungstiegel gegen eine Sputtervorrichtung zu tauschen, wobei die Sputtervorrichtung die Temperierrolle als Sputterkathode verwendet.

## Patentansprüche

1. Temperierrolle (112), aufweisend:
• eine zylinderförmige Rollenhülle (112m), welche eine Vielzahl von Gasaustrittsöffnungen (112o) aufweist;
• eine Temperiervorrichtung (1124), welche eingerichtet ist, der Rollenhülle (112m) thermische Energie zuzuführen und/oder zu entziehen;
• mehrere entlang der Drehachse erstreckte Gasleitungen (112g);
• eine Gasverteilungsstruktur (402), welche die mehreren Gasleitungen (112g) und die Vielzahl von Gasaustrittsöffnungen (112o) gasleitend miteinander koppelt,
• wobei die Gasverteilungsstruktur (402) eine kleinere auf Öffnungen bezogene Strukturdichte (1041) und/oder größere elektrische Leitfähigkeit aufweist als die Rollenhülle (112m), und
• wobei die Gasverteilungsstruktur (402) mehrere Schichten aufweist, **dadurch gekennzeichnet, dass**:
eine Schicht als Maschenwerk eingerichtet ist, das von einer Vielzahl von Perforierungen durchdrungen ist, auf welche die Strukturdichte bezogen ist und welche zwischen einer Vielzahl von Filamenten des Maschenwerks bereitgestellt sind.

2. Temperierrolle (112) gemäß Anspruch 1,
wobei die Strukturdichte (1041) auf gasleitfähige Öffnungen bezogen ist.

3. Temperierrolle (112) gemäß einem der Ansprüche 1 oder 2, wobei die Gasverteilungsstruktur (402) eine poröse Schicht aufweist, auf welche die Strukturdichte (1041) der Gasverteilungsstruktur (402) bezogen ist.

4. Temperierrolle (112) gemäß einem der Ansprüche 1 bis 3, wobei die Gasverteilungsstruktur (402) mehrere Schichten aufweist, welche sich in ihrer Strukturdichte (1041) voneinander unterscheiden.

5. Temperierrolle (112) gemäß einem der Ansprüche 1 bis 4, wobei die Gasverteilungsstruktur (402) mehrere Umfangskanäle aufweist, von denen jeder Umfangskanal die mehreren Gasleitungen (112g) gasleitend untereinander koppelt
wobei vorzugsweise von den mehreren Umfangskanälen jeder Umfangskanal um die Drehachse herum längserstreckt ist.

6. Temperierrolle (112) gemäß einem der Ansprüche 1 bis 5, wobei die Gasverteilungsstruktur (402) eine Gasverteilungsschicht aufweist, welche von einer Vielzahl von Perforierungen, auf die die Strukturdichte (1041) bezogen ist, durchdrungen ist.

7. Temperierrolle (112) gemäß einem der Ansprüche 1 bis 6, wobei die Rollenhülle (112m) einen Gradienten in der Strukturdichte (1041) aufweist.

8. Temperierrolle (112) gemäß einem der Ansprüche 1 bis 7, wobei die Rollenhülle (112m) dielektrisch ist.

9. Temperierrolle (112) gemäß einem der Ansprüche 1 bis 8, die Temperiervorrichtung (1124) aufweisend:
ein zylinderförmiges Gehäuse, welches einen Hohlraum aufweist zum Aufnehmen eines Temperierfluides, wobei die Gasverteilungsstruktur (402) beispielsweise zwischen dem Gehäuse und der Rollenhülle (112m) angeordnet ist.

10. Temperierrolle (112) gemäß einem der Ansprüche 1 bis 9, ferner aufweisend:
eine Kontaktierungsanordnung, welche elektrisch leitfähig mit der Gasverteilungsstruktur (402) verbunden ist zum Einkoppeln eines elektrischen Potentials in die Gasverteilungsstruktur (402).

11. Temperierrolle (112) gemäß einem der Ansprüche 1 bis 10, wobei die Gasverteilungsstruktur (402) mehrere elektrisch voneinander elektrisch isolierte Segmente aufweist, welche elektrisch leitfähig sind.

12. Temperierrolle (112) gemäß einem der Ansprüche 1 bis 11, wobei die Gasverteilungsstruktur (402) eine anisotrope elektrische Leitfähigkeit aufweist.

13. Transportanordnung, aufweisend:
• eine Temperierrolle (112) gemäß einem der Ansprüche 1 bis 12,
• zwei Umwickelrollen (112a, 112b), welche eingerichtet sind, zwischen diesen mittels der Temperierrolle (112) ein Substrat umzuwickeln.

14. Vakuumanordnung, aufweisend:
• eine Transportanordnung gemäß Anspruch 13,
• eine Prozessierquelle (306, 308) zum Prozessieren eines mittels der Temperierrolle (112) transportierten Substrats (102).

15. Verfahren, aufweisend:
• Umwickeln eines Substrats (102) mittels einer Temperierrolle (112) gemäß einem der Ansprüche 1 bis 12;
• Einbringen eines Gases zwischen die Temperierrolle (112) und das Substrat (102);
• Bereitstellen einer elektrischen Spannung zwischen der Temperierrolle (112) und dem Substrat (102) zum Übertragen einer elektrostatischen Anziehungskraft auf das Substrat.

## Claims

1. A temperature control roll (112), comprising:
• a cylindrical roll shell (112m), which includes a plurality of gas outlet openings (112o);
• a temperature control device (1124) which is configured to supply and/or deplete thermal energy from the roll shell (112m);
• multiple gas conduits (112g) extending along the axis of rotation;
• a gas distribution structure (402) coupling the plurality of gas conduits (112g) and the plurality of gas outlets (112o) in a gas-conducting manner with each other;
• wherein the gas distribution structure (402) includes a smaller to openings related structure density (1041) and/or greater electrical conductivity than the roll shell (112m), and
• wherein the gas distribution structure (402) comprises a plurality of layers, **characterized in that** a layer is configured as a meshwork penetrated by a plurality of perforations to which the structure density is related and which are provided between a plurality of filaments of the meshwork.

2. Temperature control roll (112) according to claim 1,
where the structure density (1041) is related to gas-conducting openings.

3. Temperature control roll (112) according to any of claims 1 or 2,
wherein the gas distribution structure (402) comprises a porous layer to which the structure density (1041) of the gas distribution structure (402) is related.

4. Temperature control roll (112) according to any of claims 1 to 3,
wherein the gas distribution structure (402) comprises multiple layers which differ from each other in their structure density (1041).

5. Temperature control roll (112) according to any of claims 1 to 4,
wherein the gas distribution structure (402) comprises a plurality of peripheral channels, of which each peripheral channel couples the plurality of gas conduits (112g) with each other in a gas-conducting manner;
whereby preferably each of the multiple peripheral channels extends lengthwise around the axis of rotation.

6. Temperature control roll (112) according to any of claims 1 to 5,
wherein the gas distribution structure (402) comprises a gas distribution layer which is penetrated by a plurality of perforations to which the structure density (1041) is related.

7. Temperature control roll (112) according to any of claims 1 to 6,
wherein the roll shell (112m) includes a gradient in the structure density (1041).

8. Temperature control roll (112) according to any of claims 1 to 7,
wherein the roll shell (112m) is dielectric.

9. Temperature control roll (112) according to any of claims 1 to 8, the temperature control device (1124) comprising:
a cylindrical housing which includes a cavity for receiving a temperature control fluid, the gas distribution structure (402) being arranged, for example, between the housing and the roll shell (112m).

10. A temperature control roll (112) according to any of claims 1 to 9, further comprising:
a contacting arrangement which is electrically conductively connected to the gas distribution structure (402) for coupling an electrical potential into the gas distribution structure (402).

11. Temperature control roll (112) according to any of claims 1 to 10,
wherein the gas distribution structure (402) comprises a plurality of segments which are electrically insulated from each other and which are electrically conductive.

12. Temperature control roll (112) according to any of claims 1 to 11,
wherein the gas distribution structure (402) includes an anisotropic electrical conductivity.

13. Transport arrangement, comprising:
• a temperature control roll (112) according to any of claims 1 to 12,
• two reeling rolls (112a, 112b), which are configured to reel a substrate between them via the temperature control roll (112).

14. Vacuum arrangement, comprising:
• a transport arrangement according to claim 13,
• a processing source (306, 308) for processing a substrate (102) transported via the temperature control roll (112).

15. A method, comprising:
• reeling a substrate (102) via a temperature control roll (112) according to any of claims 1 to 12;
• introducing a gas between the temperature control roll (112) and the substrate (102);
• providing an electrical voltage between the temperature control roll (112) and the substrate (102) for applying an electrostatic attraction force to the substrate.

## Revendications

1. Rouleau thermorégulateur (112), comprenant :
• une enveloppe cylindrique de rouleau (112m) qui présente une pluralité d'ouvertures de sortie de gaz (112o) ;
• un dispositif de régulation de température (1124) qui est conçu pour apporter et/ou retirer de l'énergie thermique à/de l'enveloppe de rouleau (112m) ;
• plusieurs conduites (112g) de gaz s'étendant le long de l'axe de rotation;
• une structure de distribution de gaz (402) couplant la pluralité de conduits de gaz (112g) et la pluralité d'orifices de sortie de gaz (112o) de manière à conduire du gaz.
• la structure de distribution de gaz (402) ayant une densité de structure (1041) plus petite par rapport aux ouvertures et/ou une conductivité électrique plus grande que l'enveloppe de rouleau (112m), et
• la structure de distribution de gaz (402) comprenant plusieurs couches, **caractérisée en ce que** :
une couche est agencée en tant que maillage pénétré par une pluralité de perforations auxquelles la densité de structure est liée et qui sont fournies entre une pluralité de filaments du maillage.

2. Rouleau thermorégulateur (112) selon la revendication 1,
où la densité de structure (1041) est lié aux ouvertures conductrices de gaz.

3. Rouleau thermorégulateur (112) selon l'une des revendications 1 ou 2,
où la structure de distribution de gaz (402) présente une couche poreuse à laquelle la densité de structure (1041) de la structure de distribution de gaz (402) est liée.

4. Rouleau thermorégulateur (112) selon l'une des revendications 1 à 3,
où la structure de distribution de gaz (402) comprend plusieurs couches qui diffèrent les unes des autres par leur densité structurelle (1041).

5. Rouleau thermorégulateur (112) selon l'une des revendications 1 à 4,
où la structure de distribution de gaz (402) comprend plusieurs canaux circonférentiels, chaque canal circonférentiel couplant les plusieurs conduits de gaz (112g) de manière à conduire le gaz entre eux de préférence, parmi les plusieurs canaux circonférentiels, chaque canal circonférentiel s'étendant dans le sens de la longueur autour de l'axe de rotation.

6. Rouleau thermorégulateur (112) selon l'une des revendications 1 à 5,
où la structure de distribution de gaz (402) comprend une couche de distribution de gaz qui est pénétrée par une pluralité de perforations auxquelles la densité de structure (1041) est liée.

7. Rouleau thermorégulateur (112) selon l'une des revendications 1 à 6,
où l'enveloppe de rouleau (112m) comprend un gradient dans la densité de structure (1041).

8. Rouleau thermorégulateur (112) selon l'une des revendications 1 à 7,
ladite enveloppe de rouleau (112m) étant diélectrique.

9. Rouleau thermorégulateur (112) selon l'une des revendications 1 à 8, le dispositif thermorégulateur (1124) présentant de plus:
un boîtier cylindrique comprenant une cavité pour recevoir un fluide de régulation de température, la structure de distribution de gaz (402) étant disposée par exemple entre le boîtier et l'enveloppe de rouleau (112m).

10. Rouleau thermorégulateur (112) selon l'une des revendications 1 à 9, présentant de plus :
un agencement de contact qui est relié de façon électriquement conductible à la structure de distribution de gaz (402) pour coupler un potentiel électrique dans la structure de distribution de gaz (402).

11. Rouleau thermorégulateur (112) selon l'une des revendications 1 à 10,
où la structure de distribution de gaz (402) comprend plusieurs segments électriquement isolés les uns des autres, qui sont électriquement conductibles.

12. Rouleau thermorégulateur (112) selon l'une des revendications 1 à 11,
où la structure de distribution de gaz (402) présente une conductivité électrique anisotrope

13. Ensemble de transport, présentant
• un rouleau thermorégulateur (112) selon l'une des revendications 1 à 12,
• deux rouleaux d'enveloppement (112a, 112b), qui sont conçus pour enrouler via le rouleau thermorégulateur un substrat entre elles (112).

14. Ensemble à vide, comprenant
• un agencement de transport selon la revendication 13,
• une source de traitement (306, 308) pour traiter un substrat (102) transporté au moyen du rouleau thermorégulateur (112).

15. Méthode comprenant
• enroulement d'un substrat (102) via un rouleau thermorégulateur (112) selon l'une des revendications 1 à 12 ;
• introduction d'un gaz entre le rouleau thermorégulateur (112) et le substrat (102) ;
• fournir une tension électrique entre le rouleau thermorégulateur (112) et le substrat (102) pour transmettre une force d'attraction électrostatique au substrat.
